# EUROPEAN PATENT APPLICATION

(11) **EP 0 553 539 A1**
(43) Date of publication of application: **04.08.1993**
(21) Application number: 92309107.8
(22) Date of filing: 06.10.1992
(51) Int. Cl.: C30B 7/00, C30B 29/58

(54) **Crystal forming device and automated crystallization system**

(30) Priority: 09.10.1991 US 774766; 17.01.1992 US 822504
(71) Applicant: SCHERING CORPORATION, Kenilworth New Jersey 07033 (US)
(72) Inventor: Kenyon, David J., Morristown, New Jersey 07960 (US); Kushner, Harold K., West Orange, New Jersey 07052 (US); Maheshwari, Rajesh K., Millburn, New Jersey 07041 (US); Perle, Abe J., Verona, New Jersey 07044 (US); Reichert, Paul, Montville, New Jersey 07045 (US); Sochon, Henry R., Clifton, New Jersey 07013 (US)
(74) Representative: Ritter, Stephen David

(57) **Abstract**

A novel crystal forming device for crystallizing macromolecules is provided which simplifies handling and is amenable to use in an automated liquid handling system. Methods for using the crystal forming device are also provided, together with automated crystallization systems which incorporate the device. These automated systems are computer controlled and are suitable for screening a wide range of conditions for crystallizing macromolecules.

## Description

### BACKGROUND OF THE INVENTION

The present invention relates generally to crystallization chambers and, more particularly, to a device for forming crystals by vapor diffusion in the hanging drop method and to an automated crystallization system.

Supersaturated solutions of macromolecules (such as proteins and nucleic acids) and peptides under conditions of defined pH, temperature and precipitant levels form crystals. Macromolecular crystals have been used in the biotechnology-pharmaceutical industry for many purposes. For example, three-dimensional models of macromolecular structures derived from X-ray diffraction analysis of crystals have been used to design new drugs in pharmaceutical research. As another example, crystallization steps are utilized in purification-manufacturing processes of biotechnology-derived products. Further, crystalline complexes such as zinc-insulin are used for controlled release drug formulations.

It is necessary, however, to produce the correct conditions for macromolecular crystallization. This requires screening a wide range of conditions. See, for example, A. McPherson, Preparation and Analysis of Protein Crystals, John Wiley and Sons, New York, New York, pages 82-127, 1982.

Various microtechniques are presently used to discover conditions for macromolecule crystallization, including, for example, the free interface diffusion method (see F.R. Salemme, Arch. Biochem. Biophys., pages 151 and 533, 1972), vapor diffusion in the hanging or sitting drop method (see A. McPherson, Preparation and Analysis of Protein Crystals, John Wiley and Sons, New York, New York, pages 96-97, 1982), and liquid dialysis (see K. Bailey, Nature, pages 145 and 934, 1940).

Of the presently used methods, vapor diffusion is the most commonly used method for growing macromolecular crystals from solution, and the most common technique used for screening conditions for crystallization is vapor diffusion in the hanging drop method. See R.H. Davies and D.M. Segal, Methods in Enzymology, Academic Press, New York, New York, Vol. 22, page 266, 1971. The vapor diffusion method has advantages over other crystallization methods because it is truly a micro-crystallization technique. Vapor diffusion in the hanging drop technique allows screening of a large range of conditions while utilizing a relatively small amount of macromolecule or peptide.

For the formation of crystals from a protein, the vapor diffusion hanging droplet method is known. A droplet containing a macromolecular solution is suspended in a sealed chamber. The macromolecular solution in the droplet is allowed to equilibrate with a reservoir containing a higher concentration of precipitating agent. Over time, water vapor diffuses from the less concentrated macromolecular solution to the more concentrated reservoir solution and slowly increases the concentration of macromolecule and precipitating agent within the droplet.

As an example, in a sealed (gas and vapor impermeable) chamber, a reservoir of, for example, 1 ml of 10% saturated ammonium sulfate, is provided. On the inside wall of the cover of the system, a 10 µl protein droplet of, for example, 5% saturated ammonium sulfate, is provided. Because of the difference in vapor pressure between the droplet and the reservoir, water will evaporate from the droplet until an equilibrium results. Thus, the droplet may shrink, for example, 50% from 10 µl to 5 µl. Crystals form under conditions of supersaturation where the concentration of macromolecules and precipitating agent in solution increase at a defined rate.

Vapor diffusion in hanging drop experiments are typically performed in 24 well tissue culture plates of the type sold by Linbro Flow Laboratories of McLean, Virginia (Linbro Tissue Culture Multiwell Plate/Cover, Catalog No. 76-033-05) and Becton Dickinson and Company of Lincoln Park, New Jersey (under the trademark FALCON 3047 MULTIWELL). The reservoir solutions are placed within each of the 24 wells of the tissue culture plate. The rim of each well is then greased with a silicon grease, such as a high vacuum grease sold by Dow Corning Corporation of Midland, Michigan. Micro cover glasses or cover slips, for example, having a No. 2 thickness and an 18 mm diameter, are siliconized with siliconizing agents, such as a siliconizing agent sold under the trademark SURFASIL by Pierce Chemical Company of Rockford, Illinois.

A 1-40 µl droplet containing a concentrated buffered solution of a homogeneous macromolecule and a precipitating agent, such as saturated ammonium sulfate, polyethylene glycol polymer, or a low molecular weight alcohol or solvent, is dispensed on each siliconized cover glass. The cover glasses are then inverted over the greased wells of the tissue culture plate and sealed by the silicon grease thereon. Typically, several components, such as buffers, salts, macromolecule concentration and precipitating agents, of both the droplet and reservoir solution in the wells are systematically varied, as well as conditions of vapor pressure, temperature, concentrations and the like.

With the cover glasses inverted, each droplet hangs down from its respective cover glass over or adjacent to the respective reservoir. Each experiment is generally allowed to equilibrate under 4°C or 22°C incubation conditions, and is monitored microscopically for crystal growth over various time intervals, for example, 3 days, 7 days, 1 month, 3 months and 6 months, although other time intervals can be used.

Typically, several thousand experiments must be performed before conditions are found to produce high quality crystals. The setup of vapor diffusion hanging drop experiments is a very labor-intensive process which must be performed by experienced technical personnel. For example, multiple aspirating and dispensing steps of components, multiple greasing and polishing steps and the like must be performed in the experimental setup. Further, for each well, a separate cover slip must be manually inverted thereover. The volume and complexity of steps can produce a wide variation in experimental results. Still further, manpower restraints usually limit the range of conditions screened for crystallization.

For the above-mentioned reasons, several research groups have developed their own automated crystallization systems.

The first robotic crystallization system based on the hanging drop method has been commercially available since 1987 from ICN Biomedicals. The system is a computer controlled sample preparation system, including a color monitor, a printer and a menu driven computer program. The system utilizes a 24 well multiwell plate and performs all of the required aspirating and dispensing steps of a classical cover glass-multiwell plate hanging drop setup. The system includes means to automatically pipette reservoir solution into the wells, and to automatically pipette droplets onto the cover glasses or cover slips. However, this system requires full time intervention of a technician to manipulate the dispensed droplets on cover glasses over the corresponding wells. In other words, the technician must still manually apply silicon grease to the rim of each well, and then invert each cover glass over its respective well. This, of course, is time consuming and burdensome.

A second approach to automated crystallization was developed at Lilly Research Laboratories in Indianapolis, Indiana in collaboration with the U.S. Naval Institute, and has been designated "APOCALYPSE", a fully automated system. See N.D. Jones et al., Annual Meeting of the American Crystallographic Association, page 27, 1987, and K.B. Ward et al., J. Crystal Growth, pages 90 and 325, 1988. The system utilizes a robot sold by Zymark Corporation under the trademark ZYMATE 11, and a Master Laboratory pipetting station. In addition, the system uses a specially designed plate sold by Flow Laboratories under the trademark CRYSTALPLATE. The plate has a 3 x 5 array of wells for crystallization experiments. Each crystallization well has two cover glasses and two oil troughs to be filled. There is a lower square-shaped oil trough surrounding a lower opening and an upper square-shaped oil trough surrounding an upper opening, the upper oil trough being larger than the lower oil trough. One cover glass is positioned over the lower oil trough to seal the lower opening and another cover glass is positioned over the upper oil trough to seal the upper opening. As a result, a sealed chamber is formed between the upper and lower cover glasses. A reservoir is formed adjacent the oil troughs and is in gaseous communication with the sealed chamber.

However, numerous operations are required to set up and seal each well. Oil must first be dispensed into each trough, Then, the reservoir must be filled. The lower cover slip is then positioned over the lower oil trough to seal the lower opening. A droplet is then deposited on the upper cover slip, which is subsequently inverted and positioned over the upper oil trough.

This specially designed plate has several advantages over the aforementioned classical cover glass-tissue culture plate set-up. First, the plate can be readily handled by a forklift hand of an articulated robotic arm such as the Zymark robot. The plate also has excellent optical visualization properties since the droplet is not viewed through a reservoir, that is, the reservoir is adjacent the droplet rather than beneath it. In addition, the plate can accommodate either hanging (from the upper cover glass), sitting (on the lower cover glass) or sandwiched (in contact with both cover glasses) drops.

However, the plate has many disadvantages. In the first place, there are cumbersome multiple cover glasses to be handled. Further, because the plate uses an oil trough to seal each well of the cover glass-crystallization chamber, additional time must be spent ensuring the correct height of the oil in the troughs. In other words, the height of the oil has to be precise to obtain a meniscus which will ensure sealing of the cover glasses. For example, if the oil height is too low, there will be no seal. On the other hand, if the oil height is too high, the oil from the upper oil trough will run into the reservoir and/or lower oil trough, and the oil from the lower oil trough will run into the reservoir. Still further, the plate has a relatively slow equilibration rate compared to comparable classical cover glass-multiwell plate experiments. Lastly, conditions for crystallizing macromolecules in this plate have been found to be considerably different from conventional hanging drop experiments.

A third approach to automated crystallization has been developed by Cryschem Corporation using the Biomek automated liquid handling system. See D. Morris et al., Biotechniques, Vol. 7, No. 5, 1989. With this approach, a specially designed plate was developed and sold under the designation MD/24 for use in this automated system. The plate has 24 wells, each well having a center post or tee for standing drops and each well being surrounded by the reservoir at a slightly lower level than the center post but in gaseous communication therewith. To provide the sealed chambers, a clear mylar film from Corning Glass Co. is sealed over the plate. Thus, there is no cover glass manipulation involved in setting up experiments. Droplets are dispensed directly on the center tee and subsequently sealed with the mylar film.

There are several disadvantages to the MD/24 plate. First, the mylar film has poor optical properties. Further, to view experiments, the mylar film must be peeled away. This disturbs the on-going vapor equilibration process. Also, after several microscopic inspections, the mylar film can no longer maintain a good seal in all the wells. These problems have inhibited wide use of the MD/24 chamber for routine screening.

In addition, various U.S. Patents show and/or disclose various crystal plate structures or the like.

For example, U.S. Patent No. 3,107,204 to Brown et al. discloses a microbiological testing method and structure therefor. The patent discloses a tray having a plurality of wells therein, and a cover for covering the tray. The cover is sealed to the tray around the outer periphery, and importantly, also includes projections which tightly fit within the wells to individually seal the same. There is no indication that there is a gaseous seal of the wells. Further, there is a snap-fitting or tight connecting seal between the cover and tray, which would make it difficult to use the same as a crystallization chamber in connection with the vapor diffusion hanging drop method for forming macromolecular crystals.

U.S. Patent No. 3,165,450 to Scheidt discloses an anaerobic culturing device formed by a shallow dish having partitions which partition the dish into four quadrants. The partitions are of a height lower than the outer wall of the dish. Thus, even when the cover is sealed to the dish, the chambers formed by the partitions are in open gaseous communication with each other. Therefore, this device could not be used to form individual sealed chambers of a crystallization chamber. See also U.S. Patent No. 3,055,808 to Henderson which is similar and suffers from the same deficiencies.

U.S. Patent No. 2,561,339 to Chediak discloses a similar arrangement, and it is clear that the wells are in open communication with each other. See also U.S. Patent No. 4,822,741 to Banes.

U.S. Patent No. 4,770,856 to Uthemann et al. discloses an arrangement in which the tray has a plurality of wells. The tray or plate has a peripheral ledge on which the cover rests. Therefore, this arrangement is similar to the FALCON 3047 MULTIWELL tissue culture plate of Becton-Dickinson and Co., and is deficient for the same reasons for use as a crystallization chamber. See also the prior art description in Figs. 2 and 3B of U.S. Patent No. 4,682,891 to de Macario et al.

U.S. Patent No. 4,012,288 to Lyman et al. discloses a tissue culture cluster dish which is similar to the FALCON 3047 MULTIWELL plate by Becton-Dickinson and Co. Although the upper ends of the well walls extend above the upper platform, the lid or cover is supported on the base such that the lower surface of the lid lies vertically above and spaced from the well walls, thereby leaving small gaps.

U.S. Patent No. 4,599,314 to Shami discloses a multiple vessel specimen tray with a lid for releasably adhering vessel covers. However, the covers are independent and separate for each vessel, that is, there is no common cover for all of the wells.

U.S. Patent No. 4,599,315 to Teraski et al. discloses a microdroplet test apparatus in which a tray is formed with multiple wells therein. The cover has various rods which project into the wells. However, the rods do not provide a sealing action, and are only used to better optically view the contents of the wells. Further, the wells are in gaseous communication with each other.

U.S. Patent No. 4,299,921 to Youssef discloses a prolonged incubation microbiological apparatus. However, there is only a single dish with a single chamber.

In addition, various patents show related automated systems.

For example, U.S. Patent No. 4,755,363 to Fujita et al. discloses an automated biopolymer crystal preparation apparatus which can prepare biopolymer single crystals by the vapor diffusion method. The apparatus controls solution supply from different reservoirs and also controls temperature. Although the patent does discuss the known hanging drop diffusion method which uses glass cover slips, this discussion only occurs in the Background portion of the patent, and the remainder of the patent is very different therefrom.

U.S. Patent No. 4,978,505 to Kertz discloses an automated system for the micropropagation and culturing of organic material. An integument roll containing a plurality of cellules is transported past a media fill apparatus where a growth medium which has its ingredients and proportions properly mixed is injected into each cellule. Bar coding means then applies a bar code to the outside of each cellule. Subsequent stations then scan to insure the appropriate amount of growth medium, heat the cellules under pressure to kill any microorganisms, cool and store the samples, and have tissue manipulations performed thereon. However, this apparatus, although describing an automated assembly, is very different from an automated crystallization system.

U.S. Patent No. 4,751,186 to Baisch et al. discloses a process for performing sample analyses and a rack for performing the process. The rack includes a plurality of cells containing reagents, the cells being inserted into reception openings in the rack. Partial samples are sucked out from the sample container and inserted in the respective cells automatically. In addition, a bar code is provided on the rack, disclosing the contents of cells. There is, however, no inversion of a single cover and the application of a sealing agent to the upper rims of the wells of a base.

U.S. Patent No. 4,927,545 to Roginski discloses a method and apparatus for the automatic processing and analysis of blood serum. Although this apparatus is not used for forming crystals, it is relevant for the disclosure of a five axis articulated robotic arm with a multi-purpose gripper and a bar code reader for identifying test tubes.

U.S. Patent No. 4,798,095 to Itoh discloses an apparatus for distributing liquid samples among test tubes and for dividing the test tubes into groups. Again, although the apparatus does not relate to a crystal forming device, it is relevant for its disclosure of a bar code labeller and a bar code reader for identifying and sorting the test tubes.

U.S. Patent No. 4,265,855 to Mandle et al. discloses an apparatus for performing immunochemical and other analyses involving phase separation. The apparatus uses magnetized tags for identifying the block of containers so that the following operations can be performed thereon: washing, reagent-adding, incubation, detection and storage. However, this apparatus is also very different from an automated crystallization system.

### SUMMARY OF THE INVENTION

The present invention provides crystal forming devices, methods and automated crystallization systems that overcome the problems of the prior art.

More particularly, this invention provides a crystal forming device comprising:
(a) a base plate having a plurality of wells therein, each well adapted to receive a reservoir solution therein and each well having a bottom and a circumferential side wall connected with said bottom to define a chamber therein, the side wall having an upper circumferential edge defining an upper opening of the well; and
(b) single removable cover means for covering all of said wells, said single removable cover means having a lower surface which rests on said upper circumferential edges of said wells to seal said wells and to thereby seal said chambers.

In one embodiment, the crystal forming device of this invention further comprises sealing means between said upper circumferential edges and said single removable cover means, for sealing the lower surface of said single removable cover means to each said well to define a plurality of sealed chambers.

The present invention further provides a method for forming macromolecular crystals, comprising the steps of:
(a) dispensing a reservoir solution in a plurality of wells formed in a base plate, with each well having a bottom and a circumferential side wall connected with said bottom to define a chamber therein, each said side wall having an upper circumferential edge defining an upper opening of the well through which the reservoir solution is dispensed;
(b) forming a plurality of droplets containing a macromolecular solution on a single cover, at positions in correspondence to said wells supplied with said reservoir solution;
(c) inverting said single cover such that said droplets remain substantially in the same positions on the single cover; and
(d) positioning said inverted single cover on said upper circumferential edges to seal said chambers, with each said droplet hanging in a suspended state over the reservoir in a respective well.

In one embodiment, the method further comprises a step of sealing the lower surface of said single removable cover means to each said well to thereby define a plurality of sealed chambers.

Preferably, a silicon sealing grease is applied to the upper circumferential edge of each well having the reservoir solution therein, prior to positioning the inverted single cover thereon.

This invention further provides an automated crystallization system comprising:
(a) liquid dispensing means for dispensing a reservoir solution in a plurality of wells formed in a base plate, each well formed by a side wall having an upper circumferential edge defining an upper opening of the well through which the reservoir solution is dispensed;
(b) droplet dispensing means for depositing a plurality of droplets containing a macromolecular solution on an upwardly facing lower surface of a cover, at positions in correspondence to said wells supplied with said reservoir solution;
(c) inverting means for inverting said cover after said droplets have been deposited thereon, such that said lower surface thereof faces downwardly; and
(d) positioning means for positioning said inverted cover on said upper circumferential edges so that said cover seals a plurality of said wells, wherein said droplets hang in a suspended state over the respective reservoir solutions.

In one embodiment, the liquid dispensing means of the automated crystallization system comprises:
(a) support platform means for supporting said base plate;
(b) pipette means for supplying the reservoir solution to each well of said base plate; and
(c) drive means for providing relative movement between said pipette means and said support platform means such that said pipette means can be selectively positioned over any one of said wells.

Another embodiment further comprises vortexing means for vibrating said support platform means after the liquids have been supplied to said wells to mix the liquids in each well.

In still another embodiment, said inverting means comprises:
(a) support platform means for supporting said cover below said droplet dispensing means; and
(b) rotation support means for rotatably supporting said support platform means between a position where the lower surface of the cover is facing upwardly to deposit the droplets thereon and a position where the lower surface of the cover is facing downwardly after the droplets are deposited on said lower surface.

In still another embodiment, said positioning means comprises articulated robotic arm means for gripping and carrying said base plate to and from said liquid dispensing means and for gripping and carrying said cover to and from said inverting means.

Still another embodiment further comprises sealant dispenser means for applying a sealant to the upper circumferential edges of the side walls of the base plate of each said crystal forming device prior to positioning of said inverted cover on said upper circumferential edges.

Yet another embodiment further comprises chamber stacking means for stacking a plurality of said crystal forming devices.

This invention further provides an automated crystallization system for use with a crystal forming device having a base plate with a plurality of wells therein and a cover for covering a plurality of said wells, said automated crystallization system comprising:
(a) chamber stacking means for stacking a plurality of said crystal forming devices;
(b) processing means for processing said crystal forming devices from said chamber stacking means, said processing means including:
   (i) liquid dispensing means for dispensing predetermined amounts of liquids into the wells of the base plate of each said crystal forming device, and
   (ii) droplet dispensing means for dispensing a droplet containing a macromolecular solution at each position on said cover corresponding to said wells such that said droplets hang in a suspended state from said cover over each well when said cover is assembled with a respective base plate; and
(c) articulated robotic arm means for gripping and carrying said crystal forming devices between said chamber stacking means and said processing means, and for disassembling and assembling the cover of each said crystal forming device with the base plate thereof.

In one embodiment said liquid dispensing means comprises:
(a) support platform means for supporting said base plate;
(b) pipette means for supplying the reservoir solution to each well of said base plate; and
(c) drive means for providing relative movement between said pipette means and said support platform means such that said pipette means can be selectively positioned over any one of said wells.

Another embodiment further comprises vortexing means for vibrating said support platform means after the liquids have been supplied to said wells to mix the liquids in each well.

Still another embodiment further comprises rotator means for rotating the cover of each said crystal forming device between a position where the lower surface of the cover is facing upwardly to deposit the droplets thereon and a position where the lower surface of the cover is facing downwardly after the droplets are deposited on said lower surface, said rotator means including support platform means for supporting said cover below said droplet dispensing means, and rotation support means for rotatably supporting said support platform means between a position where the lower surface of the cover is facing upwardly to deposit the droplets thereon and a position where the lower surface of the cover is facing downwardly after the droplets are deposited on said lower surface.

In yet another embodiment said droplet dispensing means comprises:
(a) pipette means for supplying the droplets to said cover; and
(b) drive means for providing relative movement between said pipette means and said cover such that said pipette means can be selectively positioned at different locations over the upwardly facing lower surface of the cover.

In still another embodiment said articulated robotic arm means comprises:
(a) gripping means for gripping said base plate and said cover, said gripping means including first and second gripping arms; and
(b) wrist means for holding said gripping arms in spaced apart relationship, said wrist means including gripping adjustment means for moving said gripping arms toward and away from each other.

Yet another embodiment further comprises sealant dispenser means for applying a sealant to the upper circumferential edges of the side walls of the base plate of each said crystal forming device prior to assembling said cover with the respective base plate.

Still another embodiment further comprises trolley means for retrieving said crystal forming devices from said chamber stacking means and for returning said crystal forming devices to said chamber stacking means after processing thereof has been completed.

In yet another embodiment said chamber stacking means comprises:
(a) input tower means for holding a stack of said crystal forming devices to be processed, and
(b) output tower means for holding a stack of processed crystal forming devices.

The present invention still further provides an automated crystallization system for use with a crystal forming device having a base plate with a plurality of wells therein, each well adapted to receive a reservoir solution therein and each well having a bottom and a circumferential side wall connected with said bottom to define a chamber therein, the side wall having an upper circumferential edge defining an upper opening of the well, and removable cover for covering all of said wells, said removable cover having a lower surface which rests on said upper circumferential edges of said wells to seal said wells and to thereby seal said chambers, said automated crystallization system comprising:
(a) chamber stacking means for stacking a plurality of said crystal forming devices;
(b) processing means for processing said crystal forming devices from said chamber stacking means, said processing means comprising:
   (i) sealant dispenser means for applying a sealant to the upper circumferential edge of the side wall of the base plate of each said crystal forming device,
   (ii) liquid dispensing means for dispensing predetermined amounts of liquids into the wells of the base plate of each said crystal forming device,
   (iii) droplet dispensing means for dispensing a droplet containing a macromolecular solution at each position on said cover corresponding to said wells such that said droplets hang in a suspended state from said cover over each said well when said cover is assembled with a respective said base plate, and
   (iv) rotator means for rotating the cover of each said crystal forming device between a position where the lower surface of the cover is facing upwardly to deposit the droplets thereon and a position where the lower surface of the cover is facing downwardly after the droplets are deposited on said lower surface and when said cover is assembled with a respective said base plate; and
(c) articulated robotic arm means for gripping and carrying said crystal forming devices between said chamber stacking means and said processing means, and for disassembling and assembling the cover of each said crystal forming device with the base plate thereof.

### BRIEF DESCRIPTON OF THE DRAWINGS

This invention can be more readily understood by reference to the description of the invention below and to the accompanying figures, in which:
Fig. 1 is a side elevational view, partially in phantom, of a macromolecular crystal forming device, in exploded form, which can be used with the present invention;
Fig. 2 is top plan view of the base plate of the crystal forming device of Fig. 1, viewed from line 2-2 thereof;
Fig. 3 is a bottom plan view of the single cover of the crystal forming device of Fig. 1, viewed from line 3-3 thereof;
Fig. 4 is a cross-sectional view of the base plate of the crystal forming device of Fig. 1, taken along line 4-4 thereof;
Fig. 5 is a cross-sectional view of the cover of the crystal forming device of Fig. 1, taken along line 5-5 thereof;
Fig. 6 is a cross-sectional view of a portion of the crystal forming device of Fig. 1 in assembled form and in use with the vapor diffusion hanging drop method;
Fig. 7 is a cross-sectional view of a portion of the crystal forming device of Fig. 1 in assembled form and in use with the vapor diffusion hanging drop method, in conjunction with a silicon seal;
Fig. 8 is a perspective view of an automated crystallization system according to the present invention;
Fig. 8A is a front elevational view of a portion of the automated crystallization system of Fig. 8;
Fig. 9 is a top plan view, partially in phantom, of the chamber stacking and delivery station of the automated crystallization system of Fig. 8;
Fig. 10 is a cross-sectional view of the chamber stacking and delivery station of Fig. 9, taken along line 10-10 thereof;
Fig. 11 is a cross-sectional view of the chamber stacking and delivery station of Fig. 9, taken along line 11-11 thereof;
Fig. 11A is a cross-sectional view of a portion of the elevator means of the chamber stacking and delivery station of Fig. 9, taken along line 11A-11A thereof;
Fig. 12 is a perspective view of a portion of the chamber stacking and delivery station of Fig. 9;
Fig. 13 is a top plan view of the gripper of the articulated robotic arm assembly of the present invention;
Fig. 14 is a side elevational view of the gripper of Fig. 13;
Fig. 15 is a front elevational view of the gripper of Fig. 13, rotated by 90;
Fig. 16 is a perspective view of the sealant dispensing station of the present invention;
Fig. 17 is a perspective view of the rotator station of the present invention;
Fig. 18 is a top plan view of the rotator station of Fig. 17;
Fig. 19 is a side elevational view of a portion of the rotator station of Fig. 17;
Fig. 20 is a perspective view of the chamber liquid dispensing-vortexing station of the present invention;
Fig. 21 is a top plan view of the chamber liquid dispensing-vortexing station of Fig. 20;
Fig. 22 is a side elevational view of the chamber liquid dispensing-vortexing station of Fig. 20;
Fig. 23 is a top plan view of cover waiting station of the present invention;
Fig. 24 is a side elevational view of the cover waiting station of Fig. 23;
Fig. 25 is a perspective view of a portion of the liquid handling station of the present invention;
Fig. 26 is a block diagram generally showing the components of the liquid handling station of Fig. 25;
Fig. 27 is a top plan view of the protein solution storage rack of the present invention;
Fig. 28 is a side elevational view of the protein solution storage rack of Fig. 28;
Fig. 29 is a top plan view of the assembling station of the present invention;
Fig. 30 is a side elevational view of the assembling station of Fig. 28; and
Figs. 31A-31D constitute a flow chart diagram showing the operational steps of the present invention as controlled by the computer.

### DESCRIPTION OF THE INVENTION

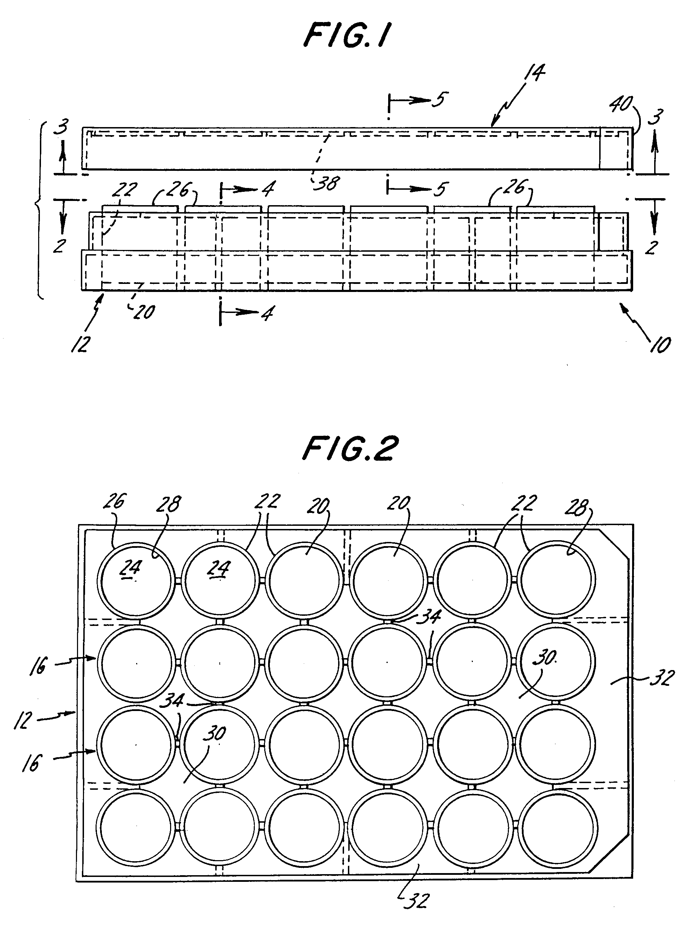

A crystal forming device 10 of the present invention is shown in Figs. 1-7. This device includes a base plate 12 and a single removable cover 14 therefor.

Base plate 12 includes a plurality of wells 16 therein, each well 16 adapted to receive a reservoir solution 18 containing a precipitating agent therein. Although twenty-four such wells 16 are shown, the present invention is not limited thereby, and this number may vary. Each well 16 has a bottom wall 20 and a cylindrical side wall 22 connected at its lower end with bottom wall 20 to define a cup-like crystallization chamber 24 therein. Only a portion of each chamber 24 is filled with reservoir solution 18. The upper circular edge or rim 26 of each side wall 22 is open to define an upper opening 28 of the respective well 16.

Bottom walls 20 of wells 16 are connected together by a bottom connecting wall 30 which extends only between adjacent bottom walls 20, while upper portions of side walls 22 are connected together by a top connecting wall 32 that extends only around the periphery of side walls 22. Wells 16 extend to a greater height than top connecting wall 32. In other words, upper circular edges 26 are higher than top connecting wall 32, and are also positioned in the same plane. This is important, as will be described in greater detail hereinafter, so that a single cover can rest directly on upper circular edges 26 to seal chambers 24, and thereby provide a plurality of individually sealed crystallization chambers. Finally, adjacent side walls 22 are connected together, along approximately the lower two-thirds height thereof, by tie connecting walls 34.

Further, a peripheral stepped side supporting wall 36 is connected to the peripheral edge of top connecting wall 32 and extends to a position below bottom connecting wall 30. In this manner, the lower edge of supporting wall 36 supports crystal forming device 10 on a flat surface.

Preferably, base plate 12 is made from a sturdy plastic material, such as a tissue culture treated polystyrene material of the type used to construct the FALCON 3047 MULTIWELL plate. The material used should be resistant to chemicals, such as methyl pentane diol, organic acids and alcohols, and should be stable for long term storage in pH 3-10 solutions. Polystyrene used in disposable multi-well plates is an inexpensive, widely used laboratory material for use in multiple tissue culture and assay applications. Characteristically, this material has good optical properties and has proven to be chemically resistant to the chemicals used in screening conditions for crystallization.

It is important that bottom walls 20 and side walls 22 are transparent or translucent for viewing the droplets suspended from cover plate 38 through a microscope or the like. However, bottom connecting wall 30 and top connecting wall 32 can be translucent or opaque to more clearly differentiate wells 16.

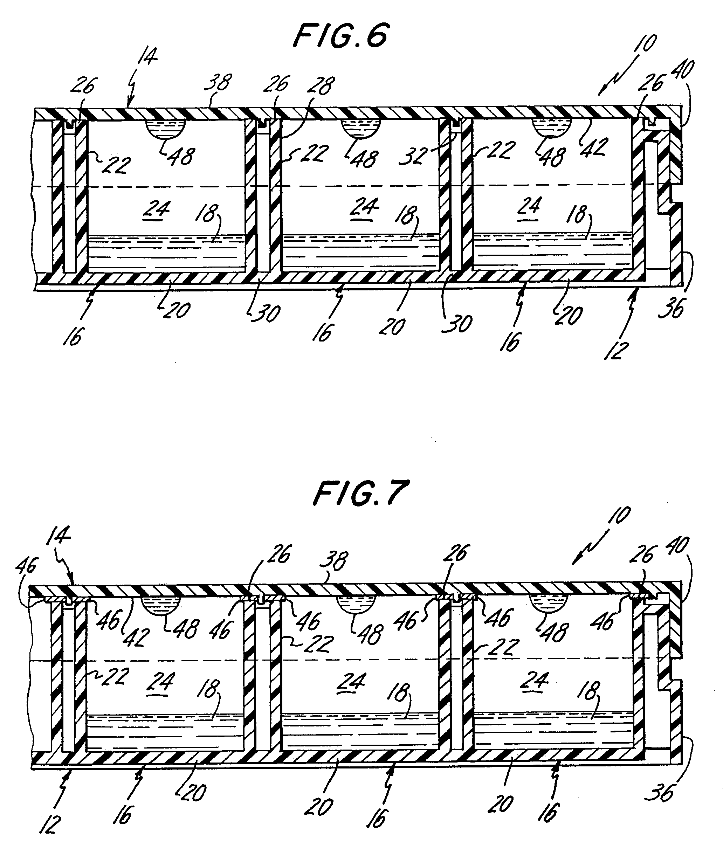

Single removable cover 14 includes a transparent flat cover plate 38 as well as a peripheral lip 40 that extends around the periphery of flat cover plate 38. Peripheral lip 40 is dimensioned to fit around the upper portion of supporting side wall 36. However, as shown in Fig. 6, the height of peripheral lip 40 is sufficiently small so that the lower edge thereof does not support cover 14 on base plate 12, but rather, as will be described in detail hereinafter, cover 14 is supported on base plate 12 only by flat cover plate 38 resting on upper circular edges 26.

Although not required, the lower or inner surface 42 of cover plate 38 has a plurality of circular beads 44 formed thereon. Each bead 44 has a diameter greater than that of upper circular edges 26 of wells 16 to extend therearound when cover 14 is positioned on base plate 12. As will be appreciated from the discussion that follows, one function of circular beads 44 is as a template for droplets containing a macromolecular solution. This design modification greatly simplifies manual crystallization screening. Such beads 44 are of the type formed on the aforementioned FALCON 3047 MULTIWELL plate.

Preferably, the entire cover 14 is made from the same transparent polystyrene material as base plate. The inner surface 42 of flat cover plate 38 is preferably siliconized to ensure better droplet formation thereon. To insure good droplet formation, a siliconizing agent is applied to prevent spreading of macromolecular droplets over time on cover 14. It was found that using a solution of SURFASIL siliconizing agent in hexane to pretreat the polystyrene surface of cover plate 38, effectively gave a uniform silicon film on polystyrene cover 14. Siliconized covers 14 allowed for comparable macromolecular droplet formation to that found for hanging drops from conventional siliconized cover glasses.

Although a sealing action may occur only with cover plate 38 sitting directly on upper circular edges 26, as shown in Fig. 6, a silicon or other grease seal 46 is preferably applied to upper circular edges 26 prior to positioning of cover 14 thereon, as shown in Fig. 7. In this manner, silicon seal 46 ensures a gaseous seal of chambers 24 when cover 14 is positioned on base plate 12, and works in conjunction with upper circular edges 26 and circular beads 44 to ensure such a seal. Any imperfections in the contact region around the 24 upper circular edges 26 of wells 16 of base plate 12, and cover 14, can be masked by using grease 46 as a sealant.

It will be appreciated that various changes can be made to crystal forming device 10. For example, although wells 16 have been shown as a having a cylindrical configuration, they could have any other suitable configuration, such as a square cross-sectional shape. As another modification, a gasket can be used to ensure the gaseous seal of each chamber in place of silicon seal 46.

A straightforward procedure which requires a minimum of easy to handle steps can therefore be followed efficiently with the present invention to screen for ideal crystallization formation.

With the present invention, wells 16 are first partially filled with a reservoir solution 18, preferably by a pipette system. A silicon grease seal 46 is then applied to upper circular edges 26 of wells 16, manually or preferably by an automated process. Then, droplets 48 containing a macromolecular solution are provided on inner surface 42 of flat cover plate 38, within each area defined by circular beads 44. Cover 14 is then inverted and positioned on upper circular edges 26. Because of silicon seal 46, chambers 24 are sealed. At this time, each droplet 48 hangs in a suspended state over its respective reservoir solution 18. The macromolecular solution in each droplet 48 is allowed to equilibrate with the respective reservoir solution 18 which contains a higher concentration of precipitating agent. Over time, water vapor diffuses from the less concentrated macromolecular solution of droplet 48 to the more concentrated reservoir solution 18 and slowly increases the concentration of macromolecule and precipitating agent within each droplet 48.

With actual experiments with crystal forming device 10, good droplet formation was observed after siliconizing cover plate 38. In such actual experiments, crystal forming device 10 was tested in side-by-side experiments with a conventional cover glass-multiwell plate in hanging drop experiments under conditions for crystallizing chicken egg white lysozyme. It was found that crystal forming device 10 gave comparable results to the conventional method. The size and quality of the crystals produced were comparable. Also, the crystals appeared after the same equilibration time as compared to conventional experiments.

The experiments proceeded as follows. A 5% solution (v/v) of SURFASIL siliconizing agent in hexane, was applied to inner surface 42 of cover plate 38 and permitted to dry. Inner surface 42 was polished with a lint free soft paper towel, and the surface was blown clean with a precision duster such as the precision duster sold under the trademark FISHERBRAND, to remove any dirt or dust on the surface.

Then, a known procedure for crystallizing hen chicken white lysozyme using the vapor diffusion hanging drop method, as published in M. Pursey et al., JBC, 261, pages 6524-6529 (1985), was set up. Droplets of 20 mg/ml chicken egg white lysozyme in 0.01 M sodium acetate with a pH of 4.0 and 4% sodium chloride, were used. The chicken egg white lysozyme was lysozyme grade I from chicken egg white, obtained from Sigma Chemical Company of St. Louis, Missouri. The sodium acetate was an anhydrous ACS reagent grade, also obtained from Sigma Chemical Company. The sodium chloride was an ACS reagent grade also obtained from Sigma Chemical Company. The droplets were equilibrated against reservoir solutions of 0.01 M sodium acetate with a pH of 4.0 and 8% sodium chloride at 22°C.

Microscopic inspections were performed using a Bausch and Lomb stereo microscope at 40x magnification. Crystal and droplet diameter measurements were made with a scalar eyepiece on the Bausch and Lomb stereo microscope.

To compare the results of the present crystal forming device 10 side-by-side with classical hanging drop experiments, several criteria were used to compare the performance of the crystallization chambers.

The ability of chambers 24 to crystallize chicken egg white lysozyme as compared to control hanging drop experiments under the same experimental conditions was tested. Experiments were set-up under identical conditions, using the same precipitating and lysozyme solutions. Twenty-four identical experiments were set up, that is, one entire plate, in both a conventional arrangement of hanging drops in a multiwell plate-cover glass arrangement and in crystallization chambers 24 of crystal forming device 10. Liquid handling, aspiration and dispensing steps into the wells of the multi-well plates and droplets onto the cover of crystal forming device 10, or on the cover glasses according to the prior art, were performed manually. Experiments were monitored by microscopic inspection at 3 days, 14 days and 30 days post set-up. The crystallization onset time (time from setup to crystal formation), crystal size (mm on edge) and number of experiments producing crystals, were monitored microscopically. The results of these experiments are shown in Table 1.

**TABLE 1**

| Method | No. Experiments | Crystal Onset Time (Days) | Crystal Size (mm) | No. Crystal Formed |
|---|---|---|---|---|
| Conventional | 24 | 3 | 0.45 | 24 |
| Present Invention | 24 | 3 | 0.45 | 22 |

It was found that the crystallization onset time was the same for both chambers. Tetragonal crystals of comparable size and quality were observed from both set of experiments. Crystals were observed in 22 out of 24 experiments in crystallization chambers of the present invention versus 24 out of 24 in the control experiments according to the prior art.

Further, droplet diameter shrinkage over time is relative to vapor evaporation rates. Microscopic measurements of change in droplet diameter were made at regular time intervals of 3 days, 14 days and 30 days. A geometric average of droplet diameters was calculated from the measurements of all the experiments. The results of these measurements are shown in Table 2.

**TABLE 2**

| Method | No. Experiments | Initial Droplet Diameter (mm) | Av. Droplet Diameters Post Set-Up (mm) | | |
|---|---|---|---|---|---|
| | | | 3 Days | 14 Days | 30 Days |
| Conventional | 24 | 3.9 | 3.5 | 3.5 | 3.5 |
| Present Invention | 24 | 3.8 | 3.5 | 3.5 | 3.5 |

In both the conventional set-up and experiments set up with crystal forming device 10, there was measurable shrinkage in all the droplets after 3 days. Thereafter, the droplet diameters stabilized out to 30 days at 22°C incubation.

These experiments confirm that device 10 having crystallization chambers 24 can be used to discover conditions for macromolecular crystallization with lysozyme. The size and quality of crystals prepared with crystal forming device 10 are comparable to control experiments. Thus, device 10 greatly reduces the complexity of handling and setting up macromolecular crystallization experiments.

The present invention is concerned with setting up crystallization experiments, using crystal forming device 10 with an automated handling system. Thus, all aspirating and dispensing stops necessary for setting up crystallization experiments can be performed in an automated process, where crystal forming devices 10 are handled by an articulated robotic arm. The present invention therefore offers distinct advantages over conventional hanging drop experiments. A minimum of handling and sealing steps is required to set-up crystallization experiments. Further, the present invention, in crystallization studies with lysozyme, gives comparable results to conventional hanging drop experiments. Experimental set-up time saved can be dedicated to screening a wider range of conditions for crystallizing macromolecules, thereby allowing greater opportunity to discover novel macromolecular crystalline forms.

Crystal forming devices 10 are adaptable to a totally automated crystallization system according to the present invention, since all steps can be automated and because device 10 can be easily manipulated by an articulated robotic arm.

The automated crystallization system 100 uses crystal forming device 10 and performs all of the aforementioned steps automatically with no human intervention. Automated crystallization system 100 is thus suitable for rapid screening of a wide range of conditions for crystallizing macromolecules and peptides, in conjunction with crystal forming device 10. The sandwich construction of crystal forming device 10 greatly simplifies liquid handling and sealing processes which are incorporated into automated crystallization system 100.

As will be described more fully below, automated crystallization system 100 uses an articulated robotic arm to move a plurality of crystal forming devices 10 to several stations, such as stacking, sealing, vortexing-liquid dispensing and chamber rotator stations. Thus, with the present invention, and with each crystal forming device 10 containing twenty-four chamber, twenty-four independent experiments can be set-up in each crystal forming device 10, and multiple crystal forming devices 10 can be set-up, without manual intervention. It has been determined that 960 experiments can be set up each day with automated crystallization system 100. Therefore, automated crystallization system 100 facilitates the discovery of novel crystal morphologies of macromolecules for numerous medical and industrial applications.

Automated crystallization system 100 includes a chamber stacking and delivery station 102 at which the crystal forming devices 10 are stacked for supply to the remainder of system 100 and to which crystal forming devices 10 are returned after being processed through automated crystallization system 100. Preferably, chamber stacking and delivery station 102 is constructed to stack twenty crystal forming devices 10 for delivery into and out of the remainder of system 100 in a typical day's run, that is, within a twenty-four hour period.

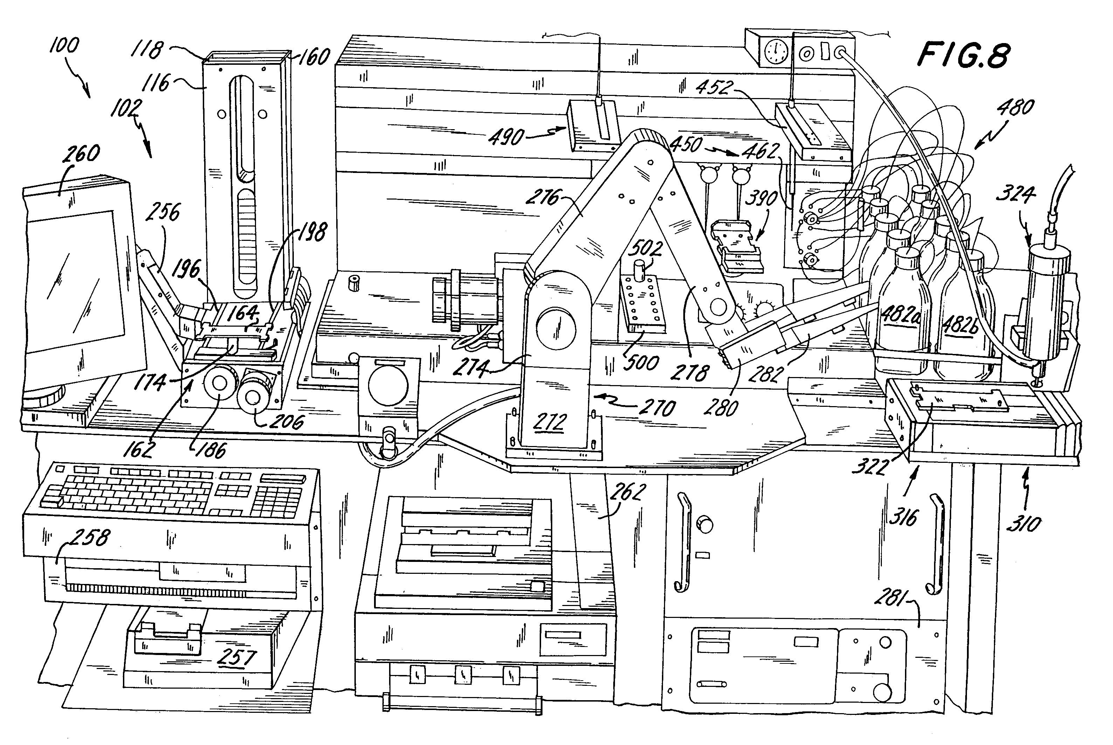

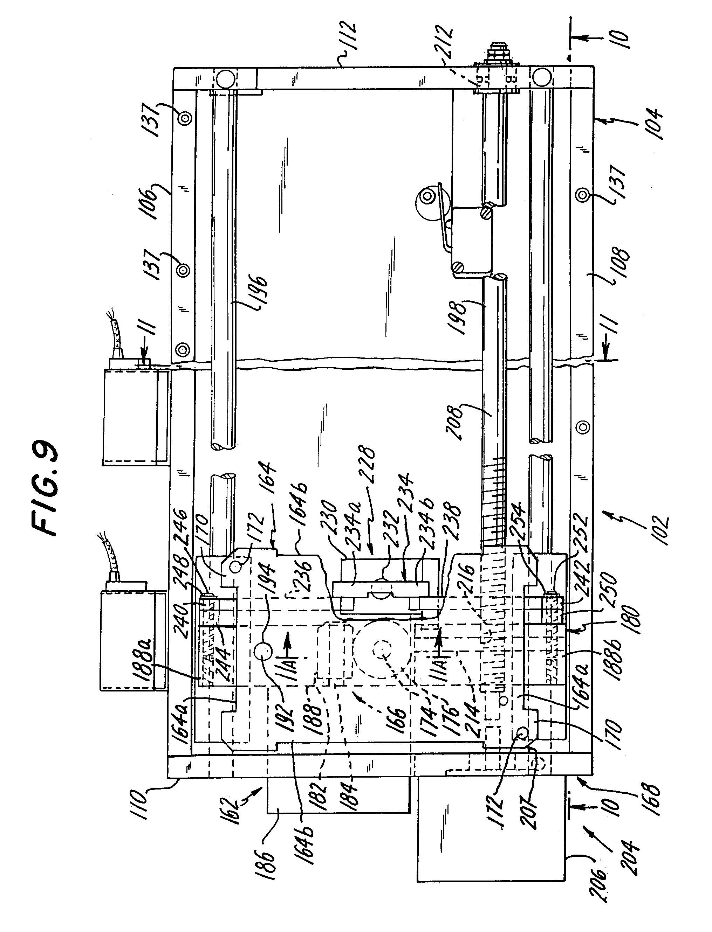

As shown in Figs. 8-12, chamber stacking and delivery station 102 includes a frame 104 formed by parallel, spaced apart side walls 106 and 108 connected together at their forward ends by a front wall 110 and connected together at their rear ends by a rear wall 112. Such connections can be made by bolts, welding or the like. As a result, frame 104 forms a rectangular box- like structure.

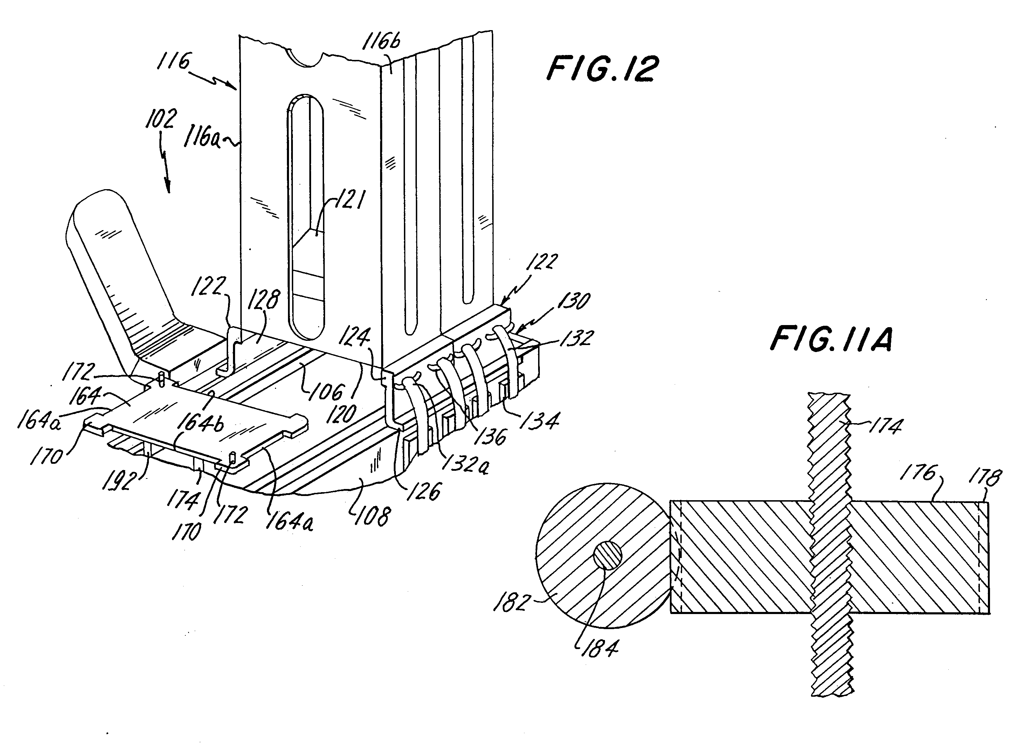

As shown in Figs. 8 and 12, an input cassette tower 116 is connected above frame 104 at the rear portion thereof. Input cassette tower 116 is adapted to hold approximately twenty crystal forming devices 10 in a stacked arrangement therein, for selective supply to the remainder of automated crystallization system 100. Input cassette tower 116 is formed as an elongated hollow rectangular box-like structure that is vertically oriented. The upper end 118 and lower end 120 of input cassette tower 116 are both open. In this manner, crystal forming devices 10 can be input by an operator through upper end 118 into input cassette tower 116, at the beginning of the operation, and can be automatically removed one at a time by automated crystallization system 100 from lower end 120. A weighted hold-down plate 121 (Fig. 12) can be placed in input cassette tower 116 on the stack of crystal forming devices 10 held therein.

Input cassette tower 116 is removably or permanently mounted on the upper edges of side walls 106 and 108 by any suitable means. In one such arrangement, Z-shaped extensions 122 are fixed to the lower edges of the side walls 116a and 116b of input cassette tower 116. Each Z-shaped extension 122 includes an upper horizontally oriented leg 124 and a lower horizontally oriented leg 126 spaced therefrom and connected thereto by a vertically oriented leg 128. Each upper horizontally oriented leg 124 is fixed to the lower edge of one side wall 116a or 116b of input cassette tower 116 by any suitable means, such as welding or the like. Each lower horizontally oriented leg 126 rests on the upper edge of one side wall 106 or 108. As a result, input cassette tower 116 is mounted on side walls 106 and 108 such that open lower end 120 thereof is positioned above and between side walls 106 and 108.

To removably secure input cassette tower 116 to side walls 106 and 108, clamping devices 130 can be provided. Clamping devices 130 are conventional devices and are similar to the clamping devices found on steamer trunks. Therefore, only a brief description will be given thereof. Each clamping device 130 includes a spring clasp 132 pivotally mounted to the outer surface of a side wall 106 or 108 by a pivot mounting element 134. The free end of each spring clasp 132 includes a hook end 132a which is adapted to engage a loop 136 mounted on the outer surface of a respective vertically oriented leg 128 of a Z-shaped extension 122. Therefore, after input cassette tower 116 is mounted on side walls 106 and 108, each hook end 132a is moved into latching engagement with a respective loop 136, and spring clasp 132 is pivoted downwardly to form a secure engagement of the hook ends 132a with loops 136 and thereby to secure input cassette tower 116 on top of side walls 106 and 108. Further, guide pins 137 can be provided on the upper edges of side walls 106 and 108 for engagement in holes (not shown) in lower horizontally oriented legs 126 to correctly align input cassette tower 116 on side walls 106 and 108.

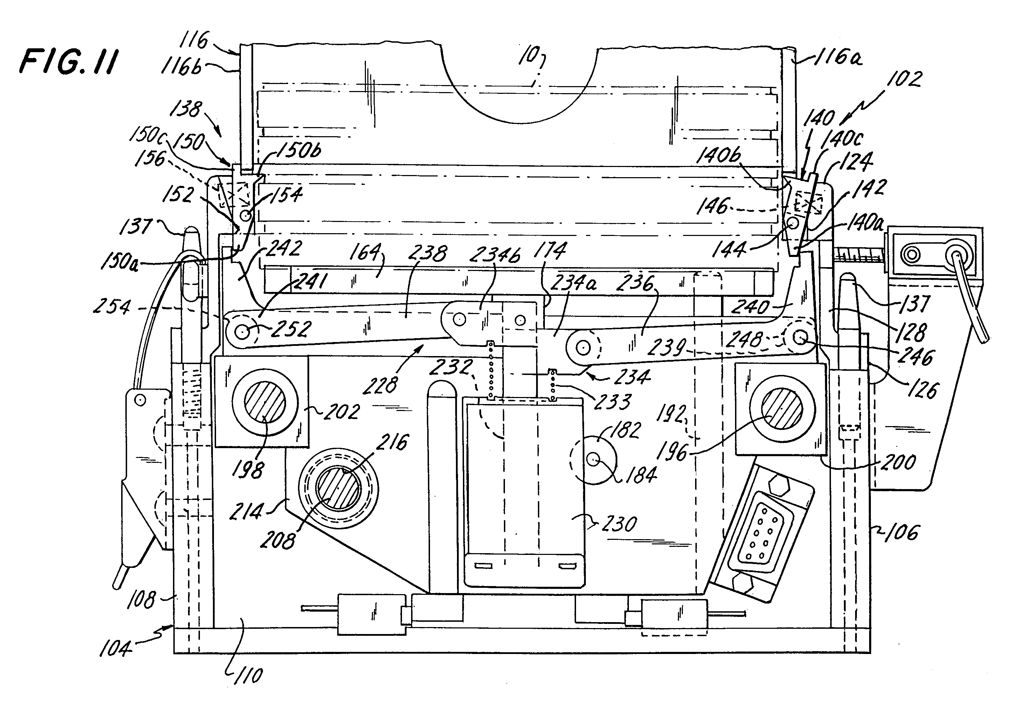

As shown in Fig. 11, input cassette tower 116 includes pivoted support means 138 for supporting a stack of crystal forming devices 10 therein at a level above side walls 106 and 108 of frame 104. Pivoted support means 138 includes a first pivoted lever 140 pivotally mounted within a recess 142 at the lower end of one side wall 116a of input cassette tower 116, by means of a pivot pin 144. Pivoted lever 140 has a lower end 140a extending below the lower edge of side wall 116a of input cassette tower 116 in spaced relation from the vertically oriented leg 128 of the associated Z-shaped extension 122. In addition, pivoted lever 140 includes an inwardly extending tapered wedge section 140b extending inwardly from an upper portion thereof. Wedge section 140b has an upper surface which is horizontally oriented when pivoted lever 140 is moved to its supporting position. In addition, pivoted lever 140 has a stop 140c positioned above wedge section 140b and which engages the outer surface of side wall 116a when biased in the counter-clockwise direction of Fig. 11, to limit the inward extent of wedge section 140b. In the position shown in Fig. 11, wedge section 140b does not engage the underside of one of the crystal forming devices 10 in input cassette tower 116, and thereby does not support that crystal forming device 10 and the stack of crystal forming devices 10 positioned thereon.

To ensure supporting engagement of a crystal forming device 10 with wedge section 140b, a spring 146 is mounted to side wall 116a for biasing lever 140 in the counter-clockwise direction of Fig. 11. Spring 146 is only shown schematically in Fig. 11, and is preferably a coil spring. However, any other form of spring can be used. For example, a torsion spring which is wound about pivot pin 144 can be provided, with one end of the torsion spring being in contact with pivoted lever 140 and the other end of the torsion spring being in contact with side wall 116a.

Pivoted support means 138 further includes a second pivoted lever 150 pivotally mounted within a recess 152 at the lower end of the other side wall 116b of input cassette tower 116, by means of a pivot pin 154. Pivoted lever 150 has a lower end 150a extending below the lower edge of side wall 116b of input cassette tower 116 in spaced relation from the vertically oriented leg 128 of the associated Z-shaped extension 122. In addition, pivoted lever 150 includes an inwardly extending tapered wedge section 150b extending inwardly from an upper portion thereof. Wedge section 150b has an upper surface which is horizontally oriented when pivoted lever 150 is moved to its supporting position, as shown in Fig. 11. In addition, pivoted lever 150 has a stop 150c positioned above wedge section 150b and which engages the outer surface of side wall 116b when biased in the clockwise direction of Fig. 11, to limit the inward extent of wedge section 150b. In the position shown in Fig. 11, wedge section 150b is in engagement with the crystal forming devices 10 in input cassette tower 116, to support the same.

To ensure supporting engagement of a crystal forming device 10 with wedge section 150b, a spring 156 is mounted to side wall 116b for biasing lever 150 in the clockwise direction of Fig. 11. Spring 156 can be a coil spring, torsion spring or the like.

It will be appreciated that levers 140 and 150 are moved in synchronism with each other and in the same manner. Therefore, when lever 150 is biased outwardly against the force of spring 156, lever 140 is also biased outwardly against the force of spring 146. The showing in Fig. 11 of levers 140 and 150 at different positions is only for explanatory purposes.

Chamber stacking and delivery station 102 also includes an output cassette tower 160 connected above frame 104 immediately behind input cassette tower 116. As with input cassette tower 116, output cassette tower 160 is adapted to hold approximately twenty crystal forming devices 10 in a stacked arrangement therein, after processing by automated crystallization system 100. Output cassette tower 160 is formed in an identical manner to input cassette tower 116, and includes the same securing means and pivoted support means.

To remove a crystal forming device 10 from input cassette tower 116 or to supply a processed crystal forming device 10 to output cassette tower 160, a trolley assembly 162 is provided. Trolley assembly 162 generally includes a support platform 164, elevator means 166 for moving support platform 164 between a raised position and a lowered position, and translation means 168 for moving support platform 164 between front wall 110 and rear wall 112.

As shown in Figs. 8, 9 and 12, support platform 164 is formed from a flat metal plate of a generally rectangular configuration. The shorter sides of platform 164 are preferably cut out, as shown at 164a, so as not to block pivoting movement of levers 140 and 150 when support platform 164 is raised within input cassette tower 116 or output cassette tower 160. In addition, the longer sides of platform 164 are cut out, as shown at 164b for a crystal forming device 10 to be manipulated by a robot arm, as described more fully below. As a result, four corner projections 170 are formed. Two pins 172 are formed on the upper surfaces of two diagonally opposite corner projections 170 for positioning a crystal forming device 10 thereon. When crystal forming device 10 is positioned on support platform 164, pins 172 just fit within the lower edge of peripheral stepped side supporting wall 36 of crystal forming device 10 to correctly align crystal forming device 10 on support platform 164.

Elevator means 166 includes a vertically movable elevator shaft 174 having one end connected centrally to the underside of support platform 164. The lower portion 174a of elevator shaft 174 is threaded, as shown in Fig. 11A, and is threadedly engaged with a worm wheel 176 having gear teeth 178 on the outer surface thereof. Worm wheel 176 is rotatably mounted to the underside of a carriage assembly 180, but is axially fixed, that is, worm wheel 176 can rotate but cannot move in the axial direction thereof. Thus, rotation of worm wheel 176 results in axial movement of elevator shaft 174, and thereby results in axial movement of support platform 164. Worm wheel 176 can be mounted by any suitable means, such as bearing races or the like, which are not shown.

Worm wheel 176 is in meshing engagement with a worm 182 fixed on the output shaft 184 of an elevator stepper motor 186 that is also fixed to the underside of carriage assembly 180 by a clamp (not shown). Thus, rotation of output shaft 184 results in rotation of worm 182 which, in turn, results in rotation of worm wheel 176.

Carriage assembly 180 is formed by a transverse block 188 extending transversely between side walls 106 and 108. Elevator shaft 174 slidably extends through a hole 190 in transverse block 188 to permit support platform 164 to be raised and lowered. In addition, to prevent rotation of support platform 164 during the vertical movement thereof, a guide shaft 192 has one end connected to the underside of support platform 164 in spaced relation to elevator shaft 174, and the opposite end is slidably engaged within another hole 194 in transverse block 188.

Translation means 168 is formed by two parallel guide rods 196 and 198 spaced apart at opposite sides of chamber stacking and delivery station 102. Guide rod 196 is secured between front wall 110 and rear wall 112, adjacent to side wall 106, while guide rod 198 is secured between front wall 110 and rear wall 112, adjacent to side wall 108.

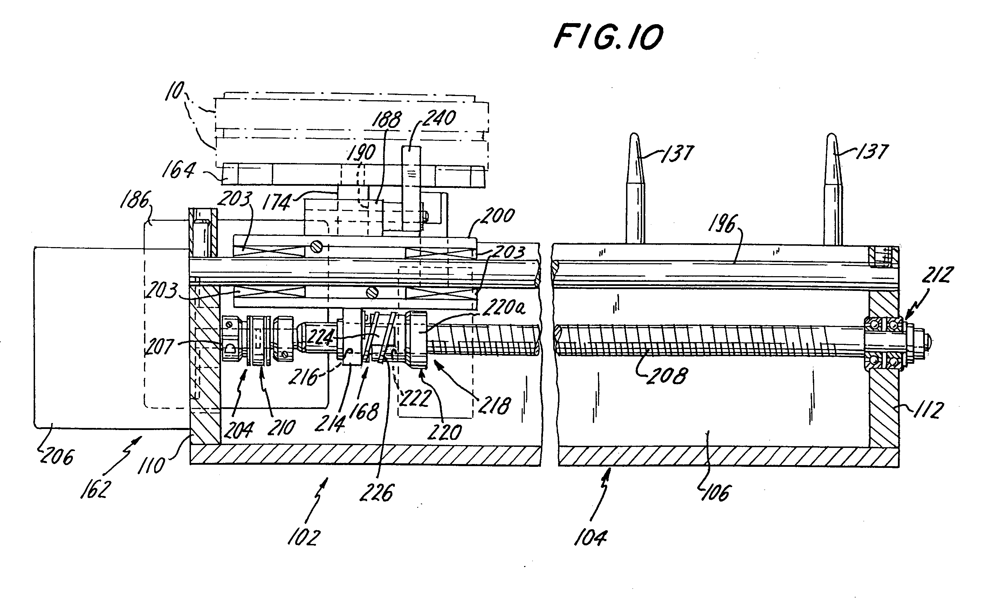

A first guide block 200 is slidably mounted on guide rod 196 and a second guide block 202 is slidably mounted on guide rod 198. As shown in Fig. 10, guide blocks 200 and 202 include bearing assemblies 203 therein for slidably mounting the guide blocks on guide rods 196 and 198. Transverse block 188 has opposite ends 188a and 188b fixedly mounted to the upper surfaces of guide blocks 200 and 202. Support platform 164 and elevator means 166 are movable with guide blocks 200 and 202 along guide rods 196 and 198.

To move guide blocks 200 and 202 along guide rods 196 and 198, a screw-thread assembly 204 is provided. Screw-thread assembly 204 includes a translation drive motor 206 mounted to the outer face of front wall 110 and having an output shaft 207 extending through front wall 110. A lead screw of threaded drive shaft 208 has one end fixedly coupled to output shaft 206 by a conventional coupling device 210, and the opposite end rotatably mounted within rear wall 112 by means of a bearing assembly 212. A driven extension block 214 is fixedly mounted to the underside of second guide block 202 and includes a threaded opening 216 which threadedly receives drive shaft 208 therein. Thus, rotation of output shaft 207 and threaded drive shaft 208 therewith, causes movement of driven extension block 214 along threaded drive shaft 208. This, in turn, causes support platform 164 and elevator assembly 166 to move therewith along guide rods 196 and 198 in a controlled manner.

To eliminate any free play of driven extension block 214 on threaded drive shaft 208, a slack take-up assembly 218 is provided, as shown in Fig. 10. A threaded member 220 is threadedly engaged on drive shaft 208 in back of extension block 214 and includes a keyway 222 on the outer surface thereof. A key member 224 is secured to the rear face of extension block 214 and engages within keyway 222. In this manner, threaded member 220 is prevented from rotating, but is movable in the axial direction of threaded drive shaft 208. A coil spring 226 is wrapped about threaded member 220 and has one end engaging an enlarged head 220a of threaded member 220 and the opposite end thereof engaging the rear face of extension block 214. As a result, extension block 214 and threaded member 220 are forced apart so that any slack in the threaded engagement of extension block 214 with threaded drive shaft 208 is removed.

Chamber stacking and delivery station 102 includes a control assembly 228 for controlling pivoted support means 138, and more particularly, for controlling pivoting movement of pivoted levers 140 and 150. A solenoid 230 is connected to extension block 214 which also hangs down from transverse block 188. Solenoid is positioned beneath support platform 174, rearwardly and substantially in line with worm wheel 176. Solenoid 230 includes a vertically reciprocable solenoid rod 232 having a yoke 234 fixed to the upper end thereof. Yoke 234 extends in the transverse direction of chamber stacking and delivery station 102. Yoke 234 is also centrally connected to the upper end of solenoid rod 232 to present opposite yoke ends 234a and 234b. In addition, a coil spring 233 is positioned between the upper surface of solenoid 230 and yoke 234 to normally bias solenoid rod 232 to its extended position, as shown by yoke end 234b in Fig. 11.

A first transverse pivot arm 236 has one end pivotally connected with yoke end 234a to extend in a direction toward side wall 106, while a second transverse pivot arm 238 has one end pivotally connected with yoke end 236a to extend in a direction toward side wall 108. The opposite end of pivot arm 236 has an upturned lever actuator 240 formed thereat, while the opposite end of pivot arm 238 has an upturned lever actuator 242 formed thereat.

The junction 239 between pivot arm 236 and lever actuator 240 is pivotally connected to end 188a of transverse block 188. A spacer block 244 is positioned between end 188a of transverse block 188 and junction 239. Junction 239 and spacer block 244 both include aligned bore holes therethrough and end 188a of transverse block 188 includes a threaded bore. A screw 246 extends through the aligned bore holes of junction 239 and spacer block 244 into threaded engagement with the threaded bore of end 188a of transverse block 188. A washer 248 is preferably interposed between the head of screw 246 and junction 239 to prevent loosening of screw 246 during the rotation of junction 239 thereabout.

In like manner, the junction 241 between pivot arm 238 and lever actuator 242 is pivotally connected to end 188b of transverse block 188. A spacer block 250 is positioned between the end 188b of transverse block 188 and junction 241. Junction 241 and spacer block 250 both include aligned bore holes therethrough and end 188b of transverse block 188 includes a threaded bore. A screw 252 extends through the aligned bore holes of junction 241 and spacer block 250 into threaded engagement with the threaded bore of end 188b of transverse block 188. A washer 254 is preferably interposed between the head of screw 252 and junction 241 to prevent loosening of screw 252 during the rotation of junction 241 thereabout.

Although lever actuators 240 and 242 are shown in different positions in Fig. 11, it will be appreciated that, in operation, both lever actuators 240 and 242 will move in the same manner, that is, both lever actuators 240 and 242 will be pivoted to the same extent. Therefore, the drawing of Fig. 11 is only for explanatory purposes.

As shown in Fig. 11, solenoid rod 232 is normally in its raised or extended position as a result of the force applied by coil spring 233. When support platform 164 is moved into a position below input cassette tower 116 or output cassette tower 160, the free ends of lever actuators 240 and 242 are positioned out of contact with and to the outside of lower ends 140a and 150a of pivoted levers 140 and 150, respectively. Therefore, crystal forming devices 10 in the respective towers 116 and 160 are still held by wedge sections 140b and 150b of pivoted levers 140 and 150. To permit the lowest crystal forming device 10 of the respective stack to be deposited on the upper surface of support platform 164, solenoid rod 232 is pulled downwardly against the force of coil spring 233 by solenoid 230. As a result, pivot arm 236 and lever actuator 240 pivot about screw 246 in the counter- clockwise direction of Fig. 11, so that the free end of lever actuator 240 hits against lower end 140a of pivoted lever 140. This results in pivoted lever 140 being biased in the clockwise direction of Fig. 11, as shown, whereby wedge section 140b thereof moves out of engagement with the stack of crystal forming devices 10.

In like manner, pivot arm 238 and lever actuator 242 pivot about screw 252 in the clockwise direction of Fig. 11 (not shown) so that the free end of lever actuator 242 hits against lower end 150a of pivoted lever 150. This results in pivoted lever 150 being biased in the counterclockwise direction of Fig. 11, whereby wedge section 150b thereof moves out of engagement with the stack of crystal forming devices 10 so that the lowest crystal forming device 10 is not carried by wedge sections 140b and 150b, but instead, is deposited and carried on the upper surface of support platform 164.

In addition, as shown in Fig. 8, chamber stacking and delivery station 102 includes a bar code reader 256 positioned immediately side wall 106 and between input cassette tower 116 and front wall 110, and connected with side wall 106. Bar code reader 256 is a conventional hand held bar code scanning reader which is mounted to chamber stacking and delivery station 102. For example, bar code reader 256 can be a CCD device sold by Wedge Opticon Inc., 8 Olympic Drive, Orangeburg, New York, under the designation "NTS-1120".

As will be understood from the discussion which follows, it is also necessary to provide a bar code printer 257 for printing labels to be applied to the different crystal forming devices 10, indicating the different processing of the same. A conventional bar code printer can also be used, such as one sold under the designation "Bar code Blazer" by Cognitive Solutions, Inc., 7850 Carelita Ave., Atasscadero, California 93442.

The bar code applied to the labels will depend upon the various parameters to be used in the crystal experiment. As discussed above, these parameters can include, for example, pH, temperature and precipitant levels. The particular parameters are chosen by an operator using a computer 258 which can be a conventional PC, such as a Compaq 386SX model 1 computer, with an 80386 processor running at 16 MHz, 1 MB of random access memory (RAM) and a 110 MB Hard disk drive. A VGA color monitor 260 and a printer 262, such as a Hewlett Packard laser Jet Series II printer can be used.

One label is applied to a side wall of the base plate 12 of each crystal forming device 10, and when trolley assembly 162 picks up a crystal forming device 10 from input cassette tower 116, bar code reader 256 scans the same, whereby computer 258 determines that it is the correct crystal forming device 10. If not, it is discarded.

Automated cry stallization system 100 further includes an articulated robotic arm assembly 270, as shown in Fig. 8. Any suitable robotic assembly can be used, such as one sold under the designation "CRS PLUS SRS-M2" by CRS Plus Inc., Burlington, Ontario, Canada, and which is also sold by Hudson Robotics, Inc., 44 Commerce Street, Springfield, New Jersey 07081. This articulated robotic arm assembly 270 includes five components, namely, a base 272, a shoulder 274, an upper arm 276, a lower arm 278 and a wrist 280. Further, a specialized gripper 282 for use with crystal forming device 10 is connected with wrist 280. Five degrees of freedom, exclusive of movement of gripper 282, are available, namely rotation around the waist (between base 272 and shoulder 274), pivoting of upper arm 276 at shoulder 274, pivoting of the elbow between upper arm 276 and lower arm 278, wrist roll (rotation) and wrist pitch (pivoting).

The position repeatability of articulated robotic arm assembly 270 is 0.002 inches along the total arm reach of 22 inches, excluding gripper 282. The lifting capacity of articulated robotic arm assembly 270 is 1 kg at maximum speed and 2 kg at 80% speed. The maximum joint speed is 60 degrees/second for the waist and shoulder and 180 degrees/second for the elbow, wrist and gripper. The operating time for a 12˝ by 2˝ pick and place cycle is 2.5 seconds.

A CRS-M2 robot system controller 281 is connected with articulated robotic arm assembly 270 for controlling the same. The CRS-M2 robot system controller 281 is conventional and is also sold by CRS Plus Inc., Burlington, Ontario, Canada, and by Hudson Robotics, Inc., 44 Commerce Street, Springfield, New Jersey 07081, along with the "CRS PLUS SRS-M2" articulated robotic arm assembly 270. The CRS-M2 robot system controller 281 includes, as standard, a 16-bit microprocessor based master controller, resident robotic automation programming language (RAPL), six DC servo amplifiers, an arm power supply and voltage regulator, and five intelligent servo axis cards. Computer 258 is interfaced with control articulated robotic arm assembly 270 through robot system controller 281.

Programming of the CRS-M2 controller 281 is through the teach pendent or resident robotic automation programming language. RAPL is an automation oriented line structured language designed to facilitate the design of applications of robot systems. RAPL uses English-like commands to provide a user friendly interface for the operator. Features of the memory, alternate command identifiers, and advanced mathematical expressions. The resident memory also has battery back-up as a standard feature. RAPL is sold along with controller 281.

Gripper 282 is a modified servo gripper sold by CRS Plus Inc. under the designation "SRS-SGRIP" and includes a programmable servo-motor controlled gripper with force and position feedback to robot system controller 281. The SRS-SGRIP gripper has a two inch maximum finger travel and is supplied with the appropriate plug-in servo card required for operation.

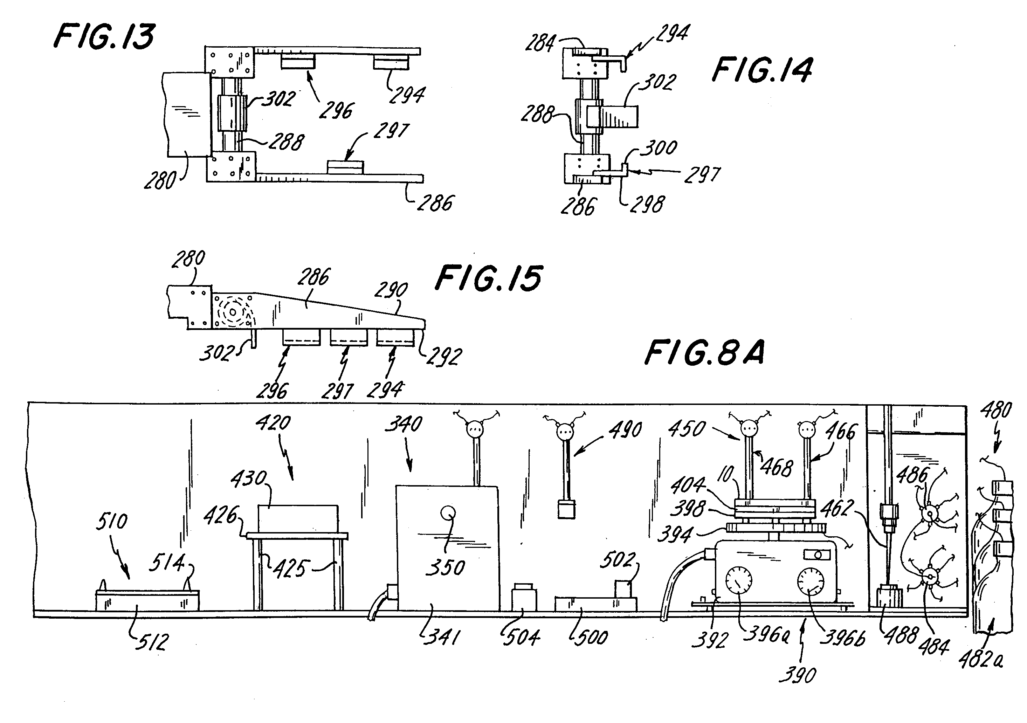

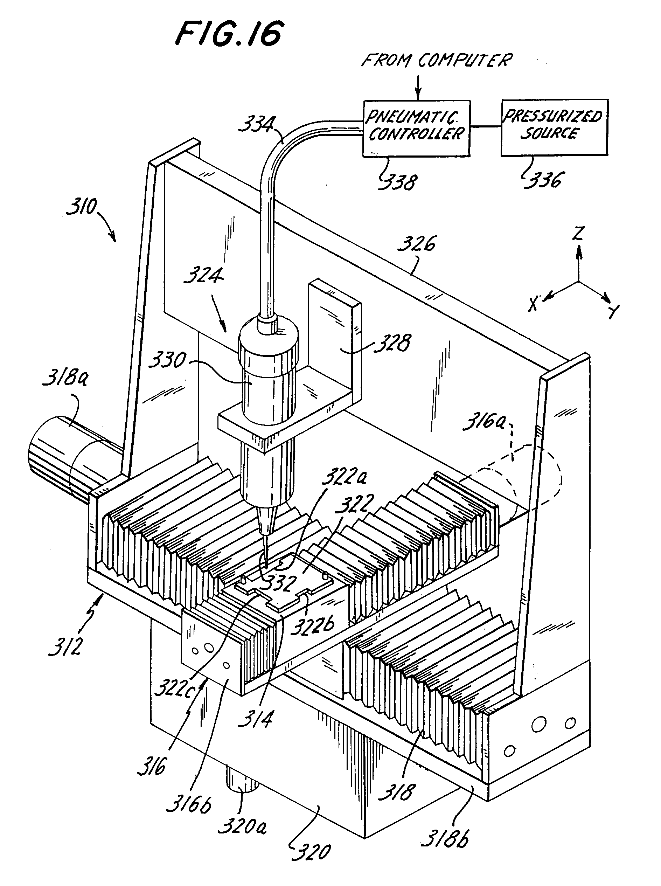

As shown in Figs. 13-15, gripper 282 includes parallel, spaced apart gripping arms 284 and 286 which are slidably mounted on a wrist pivot bar 288. Gripping arms 284 and 286 are pivotable on wrist pivot bar 288. At the same time, gripping arms 284 and 286 are movable toward and away from each along the axis of wrist pivot bar 288.

As shown, each gripping arm 284 and 286 is formed by a flat plate having a sloping upper surface 290 and a non-sloping lower surface 292, so that the height of each gripping arm 284 and 286 reduces in height from wrist 280 to the free end thereof.

Gripper 282 further includes first and second gripping members 294 and 296 secured in spaced relation along the inner surface of gripping arm 284. Preferably, gripping member 294 is formed at a forward end of gripping arm 284, while gripping member 296 is formed at a rear end of gripping arm 284. In like manner, a third gripping member 297 is secured to the inner surface of gripping arm 286 at a position between gripping members 294 and 296. Each gripping member 294, 296 and 297 is formed as an L-shaped member having a securing plate 298 and an inwardly directed holding plate 300. Each securing plate 298 is mounted to an inner surface of gripping arm 284 or 286 by any suitable means, such as welding, bolts or the like, and extends down below non- sloping lower surface 292 thereof. Each holding plate 300 is connected with the lower end of the respective securing plate 298 and extends in a direction toward the other gripping arm.

Thus, gripper 282 can be moved by articulated robotic arm assembly 270 to pick-up a crystal forming device 10, for example, from support platform 164. In such case, gripping arms 284 and 286 are moved apart a distance greater than the width at the lower end of peripheral stepped side supporting wall 36 of base plate 12. Then, gripper 282 is moved to a position in surrounding relation to the longer sides of peripheral stepped side supporting wall 36. Gripping arms 284 and 286 are then moved toward each other so that securing plates 298 thereof are pressed against the outer surfaces of the longer sides of peripheral stepped side supporting wall 36, and so that the lower edges of the longer sides of peripheral stepped side supporting wall 36 are supported on inwardly directed holding plates 300. Thereafter, with the crystal forming device 10 secured within gripper 282, gripper 282 can be moved to any desired location by articulated robotic arm assembly 270. Of course, it will be appreciated that the reverse operation occurs when a crystal forming device 10 is to be deposited and released on a surface, such as support platform 264, after processing has been completed.

To provide proper alignment of each crystal forming device 10 within gripper 282, a stop plate 302 is mounted to wrist pivot bar 288 to be pivotable therewith, and thereby, to always be perpendicular to gripping arms 284 and 286. Therefore, after a crystal forming device 10 is gripped by gripper 282, gripping arms 284 and 286 are moved to a vertically raised, slightly tilted position, and are moved slightly apart. Crystal forming device 10 held therein is thereby supported only by inwardly directed holding plates 300. As a result, crystal forming device 10 slides rearwardly toward wrist 280 until one of the shorter sides thereof abuts against stop plate 302. Then, gripping arms 284 and 286 are once again moved toward each other so that securing plates 298 are pressed against the outer surfaces of the longer sides of peripheral stepped side supporting wall 36. Thus, the position of crystal forming device 10 in gripper 282 is always the same.

After a crystal forming device 10 is picked up from support platform 164 by gripper 282, it is carried by articulated robotic arm assembly 270 to a sealant dispensing station 310 of automated crystallization system 100, as shown in Figs. 8 and 16. Sealant dispensing station 310 includes a conventional translation table 312 which, as shown schematically in Fig. 16, includes a flat support surface 314, an X- component translation means 316 for moving flat support surface 314 in an X-direction, and a Y-component translation means 318 for moving flat support surface 314 in a Y-direction which is transverse to the X-direction. It will therefore be appreciated that X-component translation means 316 and Y-component translation means 318 can move flat support surface 314 in a two- dimensional X-Y plane. In addition, although not necessary, X-component translation means 316 and Y- component translation means 318 can be mounted on a Z- component translation means 320 for moving X-component translation means 316 and Y-component translation means 318 in the vertical Z-direction transverse to the X- direction and Y-direction.

Flat support surface 314 is formed on X-component translation means 316 for movement in the X- direction. X-component translation means 316 can, for example, threadedly mount flat support surface 314 for movement on a lead screw (not shown) connected with a servo motor 316a of X-component translation means 316. Thus, activation of servo motor 316a will move flat support surface 314 in the X-direction, in a well known manner. In like manner, the support frame 316b of X- component translation means 316 can be threadedly mounted for movement in the Y-direction on a lead screw (not shown) connected with a servo motor 318a of Y-component translation means 318. Thus, activation of servo motor 318a will move flat support surface 314 in the Y- direction. Finally, the support frame 318b of Y- component translation means 318 can be threadedly mounted for movement in the Z-direction on a lead screw (not shown) connected with a servo motor 320a of Z-component translation means 320. Thus, activation of servo motor 320a will move flat support surface 314 in the Z- direction. The aforementioned assembly of translation table 312 can, for example, be a "TECHO" 3 -axis servo motor controlled table sold by EFD Inc., 977 Waterman Avenue, East Providence, Rhode Island 02914. Movement of translation table 312, that is, activation of servo motors 316a, 318a and 320a, is controlled by computer 258.

Sealant dispensing station 310 includes a support platform 322 mounted on flat support surface 314. Support platform 322 is similar to support platform 164, and specifically, is formed as a flat, substantially rectangular plate having a large cut-out section 322a on one longer side thereof for receiving first and second gripping members 294 and 296, a smaller cut-out section 322b on the opposite longer side thereof for receiving third gripping member 297, and a smaller cut-out section 322c on a shorter side thereof for receiving stop plate 302. In this manner, gripper 282 can deposit a crystal forming device 10 onto and retrieve a crystal forming device 10 from support platform 322.

Sealant dispensing station 310 further includes a sealant dispenser 324 which applies a sealant, such as the aforementioned silicon or other grease seal 46, to upper circular edges 26 of a crystal forming device 10 positioned on support platform 322, with cover 14 removed therefrom. In this manner, silicon seal 46 ensures a gaseous seal of chambers 24 when cover 14 is positioned on base plate 12, and works in conjunction with upper circular edges 26 and circular beads 44 to ensure such a seal.

Sealant dispenser 324 is fixedly mounted to a frame 326 above support platform 322 by a clamp 328 and includes a barrel 330 held by clamp 328. Barrel 330 contains the supply of sealant 46. A disposable dispensing tip 332 is connected to the lower end of barrel for dispensing a thin stream of viscous sealant 46. A sealed piston (not shown) is provided in barrel 330 for forcing the sealant out of dispensing tip 332. Barrel 330 is connected by tubing 334 to a pressurized source 336 of a gas, such as nitrogen, through a pneumatic controller 338. The later pneumatic controller 338 is controlled by computer 258. Thus, in accordance with the computer control, pneumatic controller 338 applies a predetermined pressure of nitrogen gas on the piston within barrel 330 to force a predetermined amount of sealant 46 from dispensing tip 332. Sealant dispenser 324 can be conventional, for example, the EFD 8OOD sealant dispenser sold by EFD Inc., 977 Waterman Avenue, East Providence, Rhode Island 02914.

It will be appreciated that Z-component translation means 320 could, instead of being mounted with Y- component translation means 318, be mounted for moving sealant dispenser 324 in the Z-direction.

In basic operation, a crystal forming device 10 from support platform 164 is picked up by the articulated robotic arm assembly 270 and placed on support platform 322 of sealant dispensing station 310. Then, articulated robotic arm assembly 270 grips cover 14 of crystal forming device 10 and removes the same from base plate 12 thereof. Computer 258 then automatically activates translation table 312 to position base plate 12 below dispensing tip 332 of sealant dispenser 324. Sealant dispenser 324 is thereafter controlled to dispense sealant 46 through dispensing tip 332, while translation table 312 is moved by servo motors 316a and 316b to move flat support surface 314 and thereby support platform 322, so that sealant 46 from dispensing tip 332 is deposited on the upper circular edge 26 of each well 16 of crystal forming device 10.

As discussed above, articulated robotic arm assembly 270 grips cover 14 of crystal forming device 10 and removes the same from base plate 12 thereof at sealant dispensing station 310. At about the time that sealant 46 is supplied to base plate 12, articulated robotic arm assembly 270 carries cover 14 to a rotator station 340 which rotates cover 14 by 180 degrees so that its inner surface 42 is facing up.

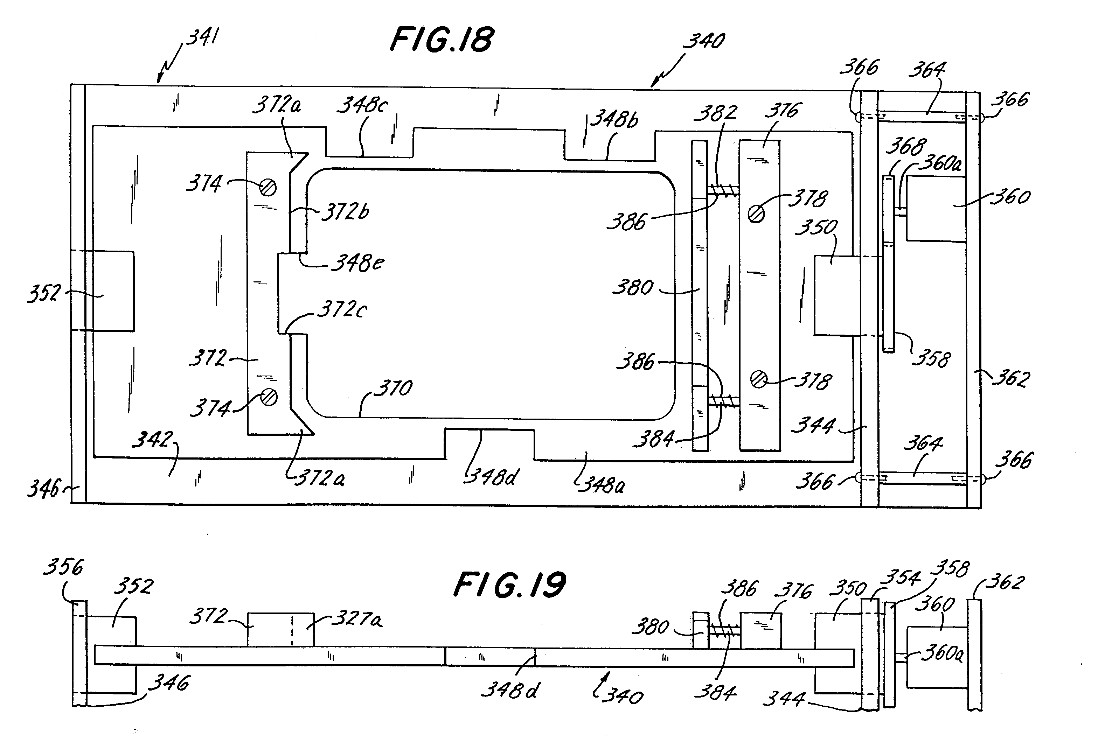

As shown in Figs. 8A and 17-19, rotator station 340 includes a frame 341 comprised of a substantially rectangular base 342 and opposite vertical support walls 344 and 346 secured to opposite shorter ends of base 342. A rotatable plate 348 is rotatably mounted between vertical support walls 344 and 346 and above base 342.

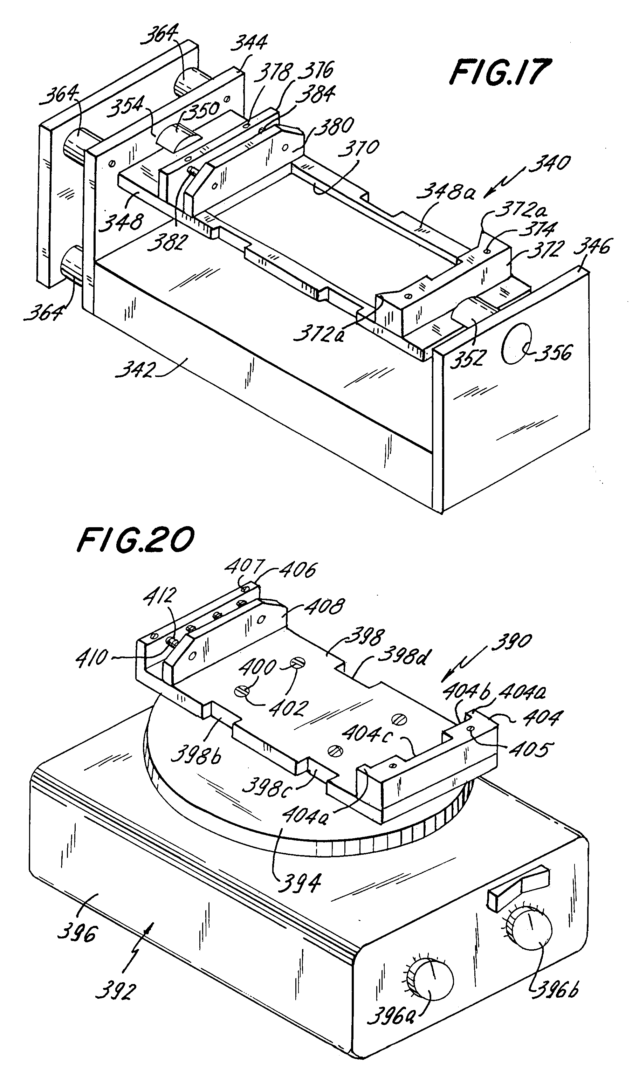

Pivot cylinders 350 and 352 are fixedly connected to the shorter ends of rotatable plate 348 and extend into bores 354 and 356 of vertical support walls 344 and 346, respectively. Further, pivot cylinder 350 extends through vertical support wall 344 and a gear 358 is secured to the free end of pivot cylinder 350 thereat. A servo motor 360 is mounted to a frame wall 362. Frame wall 362 is in parallel, spaced relation to vertical support wall 344, and is secured to vertical support wall 344 by posts 364 and bolts 366. The output shaft 360a of servo motor 360 has a gear 368 secured thereto, with gear 368 being in meshing engagement with gear 358. Servo motor 360 is controlled by computer 258 to rotate rotatable plate 348 between the position shown in Fig. 17 and a position inverted 180 degrees therefrom.

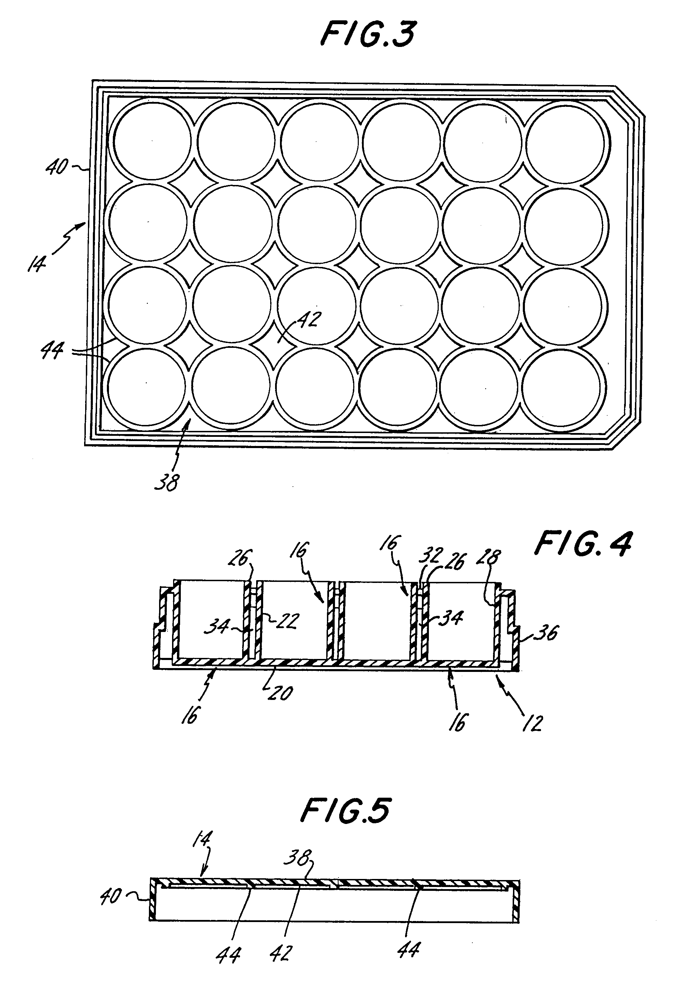

Rotatable plate 348 is preferably of a substantially rectangular configuration with an upper surface 348a and including a central rectangular opening 370. A fixed stop block 372 is fixedly mounted by bolts 374 on upper surface 348a adjacent one shorter side of opening 370. As shown, fixed stop block 372 is of a generally rectangular configuration, with triangular wings 372a extending toward the opposite end of opening 370. As a result, the inner surface 372b of fixed stop block 372 has a configuration similar to the beveled side of cover 14, as shown in Fig. 3.

A fixed barrier wall 376 is fixedly mounted by bolts 378 on upper surface 348a of rotatable plate 348 at the opposite end of opening 370. As shown, fixed barrier wall 376 is spaced from opening 370. A movable stop block 380 is mounted on upper surface 348a of rotatable plate 348 for movement in the lengthwise direction of opening 370. First and second telescoping rod sets 382 and 384 are mounted between fixed barrier wall 376 and movable stop block 380 to permit movement of movable stop block 380 in the lengthwise direction of opening 370 while retaining movable stop block 380 on upper surface 348a of rotatable plate 348. A coil spring 386 is wrapped around each telescoping rod set 382 and 384 for biasing movable stop block 380 in a direction toward fixed stop block 372.

Rotatable plate 348 is formed with first and second cut-out sections 348b and 348c on one longer side thereof for receiving first and second gripping members 294 and 296, and a third cut-out section 348d on the opposite longer side thereof for receiving third gripping member 297. In addition, fixed stop block 372 is formed with a central cut-out section 372c on the inner surface 372b thereof and rotatable plate 348 is formed with a cut-out section 348e on the shorter side thereof in alignment with cut-out section 372c, for receiving stop plate 302 of gripper 282. In this manner, gripper 282 can deposit a cover 14 onto and retrieve a cover 14 from rotatable plate 348.

To insert cover 14 within rotator station 340, gripper 282 is moved into position above rotatable plate 348, and inserts the end of cover 14 adjacent movable stop block 380 down first into engagement with movable stop block 380. Then, gripper 282 moves cover 14 rearwardly a small amount so that movable stop block 380 moves rearwardly against the action of coil springs 386. The opposite end of cover 14 is then placed on upper surface 348a of rotatable plate 348. In such movements, it will be appreciated that gripping members 294, 296 and 297 move within the confines of cut-out sections 348b, 348c and 348d, respectively, and stop plate 302 of gripper 282 moves within the confines of cut-out sections 348e and 372c. Thereafter, gripping arms 284 and 286 are moved apart to release cover 14, whereupon coil springs 386 bias movable stop block 380 to push cover 14 a small distance in a direction into engagement with fixed stop block 372. Cover 14 is held in a fixed position between fixed stop block 372 and movable stop block 380. Thereafter, rotatable plate 348 is rotated by 180 degrees so that lower or inner surface 42 of cover 14 is facing upwardly and is exposed through opening 370.

After sealant 46 is dispensed on upper circular edges 26 of the base plate 12 of crystal forming device 10 positioned on support platform 322, base plate 12 thereat is picked up by articulated robotic arm assembly 270 and delivered to a chamber liquid dispensing-vortexing station 390 where specified volumes of solutions containing a precipitating agent are supplied to each of the twenty-four wells 16 of base plate 12.

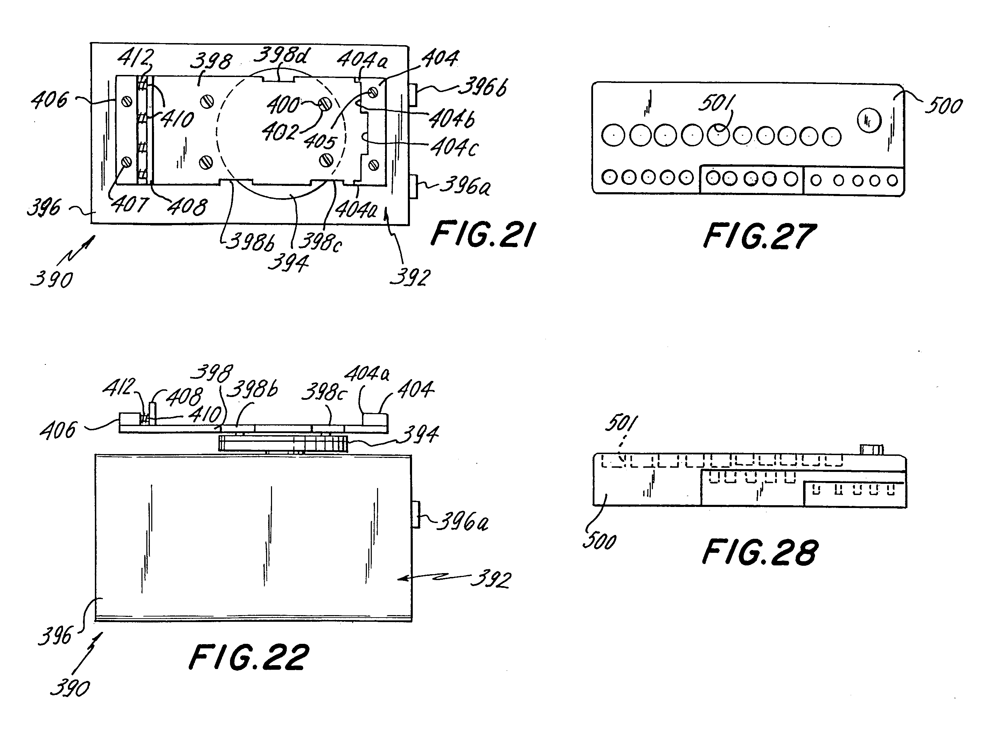

As shown in Figs. 8, 8A and 20-22, chamber liquid dispensing-vortexing station 390 includes a vortexer or shaker assembly 392, for example, a shaker assembly sold under the designation "TITERTEK 4 PLATE SHAKER" by Flow Industries, Inc. of McLean, Virginia. Such a shaker assembly 392 includes a shaker table 394 mounted on a base 396 which houses the electronics and shaking mechanisms to cause shaker table 394 to vibrate at a high frequency, back and forth and up and down by small distances. The amount of time that shaker table 394 is caused to vibrate and the speed or frequency of vibration can be set by knobs 396a and 396b, respectively. Such shaker assembly 392 is well known and will not be described further herein, except to state that shaker assembly 392 is activated and controlled by computer 258.

Chamber liquid dispensing-vortexing station 390 further includes a support plate 398 which is preferably of a substantially rectangular configuration. Support plate 398 is fixed on shaker table 394 by means of bolts 400 extending through recessed openings 402 in the upper surface 398a of support plate 398 into threaded engagement with threaded openings (not shown) in shaker table 394.

A fixed stop block 404 is fixedly mounted by bolts 405 on upper surface 398a at one shorter side of support plate 398. As shown, fixed stop block 404 is of a generally rectangular configuration, with small ears 404a formed at opposite sides thereof and extending toward the opposite shorter end of support plate 398. As a result, the shorter side of base plate 12 will just fit between ears 404a. In addition, inner surface 404b of fixed stop block 404 is formed with a cut-out section 404c which is adapted to receive stop plate 302 of gripper 282.

A fixed barrier wall 406 is fixedly mounted by bolts 407 on upper surface 398a of support plate 398 at the opposite shorter side thereof. As shown, a movable stop block 408 is mounted on upper surface 398a of support plate 398 for movement in the lengthwise direction of support plate 398, toward fixed stop block 404. Four telescoping rod sets 410 are mounted between fixed barrier wall 406 and movable stop block 408 to permit movement of movable stop block 408 in the lengthwise direction of support plate 398, while retaining movable stop block 408 on upper surface 398a of rotatable plate 398. A coil spring 412 is wrapped around each telescoping rod set 410 for biasing movable stop block 408 in a direction toward fixed stop block 404.

Support plate 398 is formed with first and second cut-out sections 398b and 398c on one longer side thereof for receiving first and second gripping members 294 and 296, and a third cut-out section 398d on the opposite longer side thereof for receiving third gripping member 297. In this manner, gripper 282 can deposit a crystal forming device 10 onto and retrieve a crystal forming device 10 from support plate 398.

To insert base plate 12 having sealant 46 thereon, on support plate 398, gripper 282 grips the base plate 12 on support platform 322 after sealant 46 has been supplied thereto. Gripper 282 then moves base plate 12 into a position above support plate 398, and inserts the end of base plate 12 adjacent movable stop block 408 down first into engagement with movable stop block 408. Then, gripper 282 moves base plate 12 rearwardly a small amount so that movable stop block 408 moves rearwardly against the action of coil springs 412. The opposite end of base plate 12 is then placed on upper surface 398a of support plate 398. In such movements, it will be appreciated that gripping members 294, 296 and 297 move within the confines of cut-out sections 398b, 398c and 398d, respectively, and stop plate 302 of gripper 282 moves within the confines of cut-out section 404c. Thereafter, gripping arms 284 and 286 are moved apart to release base plate 12, whereupon coil springs 412 bias movable stop block 380 to push base plate 12 a small distance in a direction into engagement with fixed stop block 404. Base plate 12 is held in a fixed position between fixed stop block 404 and movable stop block 408.

To increase the efficiency of automated crystallization system 100, articulated robotic arm assembly 270 retrieves the next crystal forming device 10 presented by chamber stacking and delivery station 102 and delivers the same onto support platform 322 of sealant dispensing station 310. Thereafter, articulated robotic arm assembly 270 removes cover 14 of such crystal forming device 10 at sealant dispensing station 310 and supplies the same to a cover waiting station 420 which is shown in Figs. 8A, 23 and 24.

Cover waiting station 420 is substantially identical to rotator station 340, except that there is no rotation thereat. This is because the cover 14 placed on cover waiting station is merely placed in a waiting state and no processing occurs at such station.

Cover waiting station 420 includes a frame 422 comprised of a substantially rectangular base 424 having four vertical posts 425 mounted at the four corners of base 424. A support plate 426 is mounted on the upper ends of vertical posts 425 and above base 424.

Support plate 426 is preferably of a substantially rectangular configuration with an upper surface 426a and including a central rectangular opening 428. A fixed stop block 430 is fixedly mounted by bolts 431 on upper surface 426a adjacent one shorter side of opening 428. As shown, fixed stop block 430 is of a generally rectangular configuration, with triangular wings 430a extending toward the opposite end of opening 428. As a result, the inner surface 430b of fixed stop block 430 has a configuration similar to the beveled side of cover 14, as shown in Fig. 3.

A fixed barrier wall 432 is fixedly mounted by bolts 434 on upper surface 426a of support plate 426 at the opposite end of opening 428. As shown, fixed barrier wall 432 is spaced from opening 428. A movable stop block 436 is mounted on upper surface 426a of support plate 426 for movement in the lengthwise direction of opening 428. First and second telescoping rod sets 438 and 440 are mounted between fixed barrier wall 432 and movable stop block 436 to permit movement of movable stop block 436 in the lengthwise direction of opening 428 while retaining movable stop block 436 on upper surface 426a of support plate 426. A coil spring 442 is wrapped around each telescoping rod set 438 and 440 for biasing movable stop block 436 in a direction toward fixed stop block 430.

Support plate 426 is formed with first and second cut-out sections 426b and 426c on one longer side thereof for receiving first and second gripping members 294 and 296, and a third cut-out section 426d on the opposite longer side thereof for receiving third gripping member 297. In addition, fixed stop block 430 is formed with a central cut-out section 430c on the inner surface 430b thereof, for receiving stop plate 302 of gripper 282. In this manner, gripper 282 can deposit a cover 14 onto and retrieve a cover 14 from support plate 426.

To insert cover 14 on cover waiting station 420, gripper 282 is moved into position above support plate 426, and inserts the end of cover 14 adjacent movable stop block 436 down first into engagement with movable stop block 436. Then, gripper 282 moves cover 14 rearwardly a small amount so that movable stop block 436 moves rearwardly against the action of coil springs 442. The opposite end of cover 14 is then placed on upper surface 426a of support plate 426. In such movements, it will be appreciated that gripping members 294, 296 and 297 move within the confines of cut-out sections 426b, 426c and 426d, respectively, and stop plate 302 of gripper 282 moves within the confines of cut-out section 430c. Thereafter, gripping arms 284 and 286 are moved apart to release cover 14, whereupon coil springs 442 bias movable stop block 436 to push cover 14 a small distance in a direction into engagement with fixed stop block 430. Cover 14 is held in a fixed position between fixed stop block 430 and movable stop block 436.

After the cover 14 is removed and supplied to cover waiting station 420, sealant 46 is applied to upper circular edges 26 of the base plate 12 corresponding to the cover 14 at cover waiting station 420. This occurs at sealant dispensing station 310. After processing of the first crystal forming device 10 at rotator station 340 and chamber liquid dispensing-vortexing station 390, the next base plate 12 at sealant dispensing station 310 is ready for immediate delivery to chamber liquid dispensing-vortexing station 390 for processing thereat.

At the same time that sealant 46 is being applied to upper circular edges 26 of the base plate 12 at sealant dispensing station 310, a liquid handling station 450, which is positioned above and adjacent to chamber liquid dispensing-vortexing station 390, supplies specified volumes of solutions containing a precipitating agent to each of the twenty-four wells 16 of base plate 12 at chamber liquid dispensing-vortexing station 390.

Liquid handling station 450 uses a robotic sample processor (RSP), Model No. 5052, sold by Tecan U.S. Ltd., P.O. Box 8101, Hillsborough, North Carolina, 27278. The TECAN RSP 5052 liquid handling station 450 automatically dispenses specified volumes of bulk solutions (up to ten solutions) from a bulk solution storage area through a first pipetting arm 452 into each of the twenty-four wells of base plate 12 positioned at chamber liquid dispensing-vortexing station 390. This system has a pipetting accuracy between supply levels of 5-1000 µl. Thus, liquids (buffers, precipitants and special additives) can be dispensed into reservoir wells 16 in the range of 5-1000 µl.

Since such a robotic sample processor is well known, only a brief description thereof will be given with respect to Figs. 8, 25 and 26. First pipetting arm 452 is mounted to a rear frame 454 positioned behind chamber liquid dispensing-vortexing station 390, for movement in a first X-direction along rear frame 454 by an X-direction drive assembly (not shown). First pipetting arm 452 extends above base plate 12 at chamber liquid dispensing- vortexing station 390. First pipetting arm 452 includes an elongated drive slot 457 which mounts a vertically oriented pipette holder 458 therein, for movement along slot 457. First pipetting arm 452 includes a Y-direction drive assembly (not shown) therein for moving pipette holder 458 in the Y-direction along slot 457, which is transverse to the aforementioned X- direction. Finally, pipette holder 458 holds a vertically oriented pipette 462 therein and includes a Z- direction drive assembly (not shown) for moving pipette 462 in the vertical or Z-direction. Pipette 462 can move in the X, Y and Z directions to be positioned over any well 16 of base plate 12 to supply a solution thereto. The X, Y and Z-direction drive assemblies are shown schematically by block 464 in Fig. 26.

Pipette 462 of the TECAN RSP 5052 liquid handling station 450 is sold having a large volume pipette dispenser (not shown) and a small volume pipette dispenser (not shown) built into pipette 462, the different dispensers being used with a single pipette tip 463, depending upon the amount of solution to be supplied through pipette 462. As shown, a first valve assembly 466 is formed along rear frame 454 for supplying a liquid to the large volume pipette dispenser of pipette 462 of liquid handling station 450, and a second valve assembly 468 is formed along rear frame 454 for supplying a liquid to the small volume pipette dispenser of pipette 462 of liquid handling station 450.

Of course, a single pipette dispenser could be provided with pipette 462 to eliminate the need for first and second valve assemblies 466 and 468.

This well known arrangement of valve assemblies 466 and 468 is shown in block diagram in Fig. 26. As shown therein, pipette 462 is controlled by the XYZ drive assemblies 464 to move over the different wells 16 of base plate 12. This movement is controlled by computer 258.

Then, liquid from a liquid supply is provided both to first valve assembly 466 and second valve assembly 468, both of which are computer controlled. However, only one valve assembly 466 or 468 is opened. The other port from each valve assembly 466 and 468 is connected through a coupler 470 to pipette 462. Thus, liquid from the supply passes through the open valve to pipette 462, and more particularly, to the respective pipette dispenser built into pipette 462, and then to pipette tip 463. This predetermined amount of liquid is dispensed by the pipette assembly in a well known manner, to the respective well 16. It will be appreciated, as well known with the TECAN RSP 5052 liquid handling station 450, and as shown in block form in Fig. 26, that a suction or vacuum system 465 is connected with pipette 462 to draw the liquid into pipette 462 for dispensing.

Preferably, there are a number of different liquids that can be deposited into each well 16. Thus, as shown in Figs. 8, 8A and 26, a bulk solution dispensing station 480 is provided. Preferably, bulk solution dispensing station 480 includes ten one-liter glass bottles 482a-482j, each containing a different liquid. Bottles 482a-482j can be gas sparged, for example, with nitrogen or argon gas.

Two six-way valves 484 and 486 are provided for selectively supplying liquid from each bottle 482a-482j to first and second valve assemblies 466 and 468. First six-way valve 484 has five input ports 1-5 connected with bottles 482a-482e, and its output port connected with input port 6 of second six-way valve 486. The other input ports 1-5 of second six-way valve 486 are connected with the remaining bottles 482f-482j and the output port thereof is connected with input ports of valve assemblies 466 and 468.

Pipette 462 is moved over each well 16, and liquids from bottles 482a-482j are selectively supplied to each well 16 through pipette 462. In general operation, liquid from bottle 482a will be supplied to selected wells 16, as determined by computer 258, as pipette 462 is moved over these wells. Then, liquid from bottle 482b will be supplied to selected wells 16 as pipette 462 is moved thereover, and so on, until the desired amounts of the different liquids are dispensed into wells 16.

In between the dispensing of the liquids from bulk liquid storage station 480, pipette 462 is flushed to insure there is no cross contamination of the added liquid components. This occurs as follows. After liquid from bottle 482a is dispensed to each of the selected wells 16, liquid from bottle 482b is supplied through the aforementioned valve arrangement to pipette 462. Pipette 462 oscillates the new liquid from bottle 482b up and down approximately twenty times by means of suction system 465, and then dispenses the same in a washing or waste station 488 positioned adjacent to chamber liquid dispensing-vortexing station 390. Therefore, the lines are flushed with the new liquid so that there is no contamination. Thereafter, the liquid from bottle 482b is drawn again in the desired amount and dispensed accurately to selected wells 16.

Once the dispensing operation is complete, base plate 12 at chamber liquid dispensing-vortexing station 390 is vortexed by remote activation of shaker assembly 392 for a predetermined time period in the range of 1 to 999 seconds, to insure uniform mixing of all of the added liquid components.

Thereafter, a droplet 48 containing a macromolecular solution is deposited within each of those circular beads 44 of the cover 14 positioned at rotator station 340 which correspond to wells 16 having a liquid added thereto. This is performed by a droplet dispensing station 490 positioned above rotator station 340. Droplet dispensing station 490 forms part of the aforementioned robotic sample processor (RSP), Model No. 5052, sold by Tecan U.S. Ltd., P.O. Box 8101, Hillsborough, North Carolina, 27278, as shown in Figs. 8 and 25.

Droplet dispensing station 490 includes a second pipetting arm 492 and a pipette 494 mounted for movement therewith, which are identical in construction to first pipetting arm 452 and pipette 462, respectively. It will be appreciated that the XYZ drive assembly for pipette 494 is identical to the XYZ drive assembly 464 for pipette 462, and accordingly, will not be discussed in detail. Second pipette 494 automatically dispenses specified volumes of solutions onto cover 14 within specified ones of circular beads 44, as determined by computer 258. This second pipetting assembly can aspirate droplets 48 to be hung over the corresponding reservoir wells 16 of the respective base plate 12 in the range of 1-40 µl.

For use with droplet dispensing station 490, a protein solution storage rack 500 having a plurality of different diameter recesses 501 is provided, with at least one test tube 502 being positioned in one recess 501, the test tube 502 containing a protein solution therein.

In operation of droplet dispensing station 490, pipette 494 aspirates 1-40 µl of liquid from a test tube 502 in protein solution storage rack 500, and subsequently picks up 1-40 µl of solution in a first well 16 of base plate 12 sitting in chamber liquid dispensing- vortexing station 390. This combination is then mixed in the tip of pipette 494. For example, by use of suction, the mixture is caused to oscillate up and down in the tip of pipette 494 to thoroughly mix the same. This mixture is then dispensed as a droplet 48 on the mirror image position of cover 14 corresponding to the first well 16 from which the liquid was drawn. This is accomplished from a programmed distance and with a dispensing speed, allowing optimum droplet formation. Pipette 494 then draws a water solution, and by means of suction oscillation, rinses the tip thereof. The water is then expelled into another waste station 504. Then, pipette 494 again aspirates 1-40 µl of liquid from test tube 502 in protein solution storage rack 500, and subsequently picks up 1-40 µl of solution in a second well 16 of base plate 12 sitting in chamber liquid dispensing-vortexing station 390. This combination is then mixed in the tip of pipette 494. For example, by use of suction, the mixture is caused to oscillate up and down in the tip of pipette 494 to thoroughly mix the same. This mixture is then dispensed on the mirror image position of cover 14 corresponding to the second well 16 from which the liquid was drawn. This operation is repeated for each of the twenty-four positions on cover 14, corresponding to the twenty-four wells 16.

Thereafter, cover 14 is automatically rotated 180 degrees to its original position. Droplets 48 remain in the same position, suspended from the underside of cover 14.

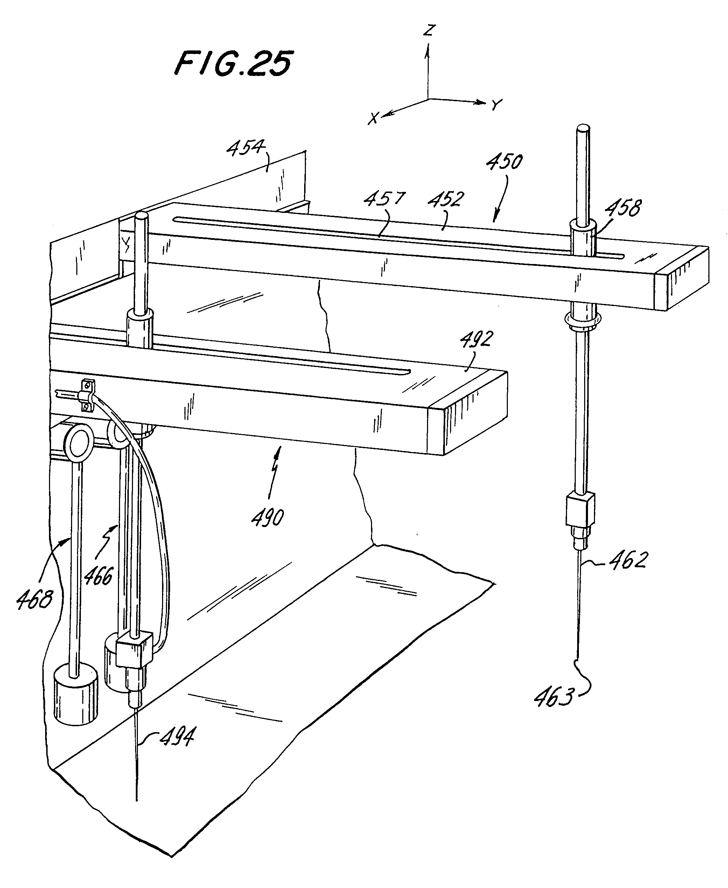

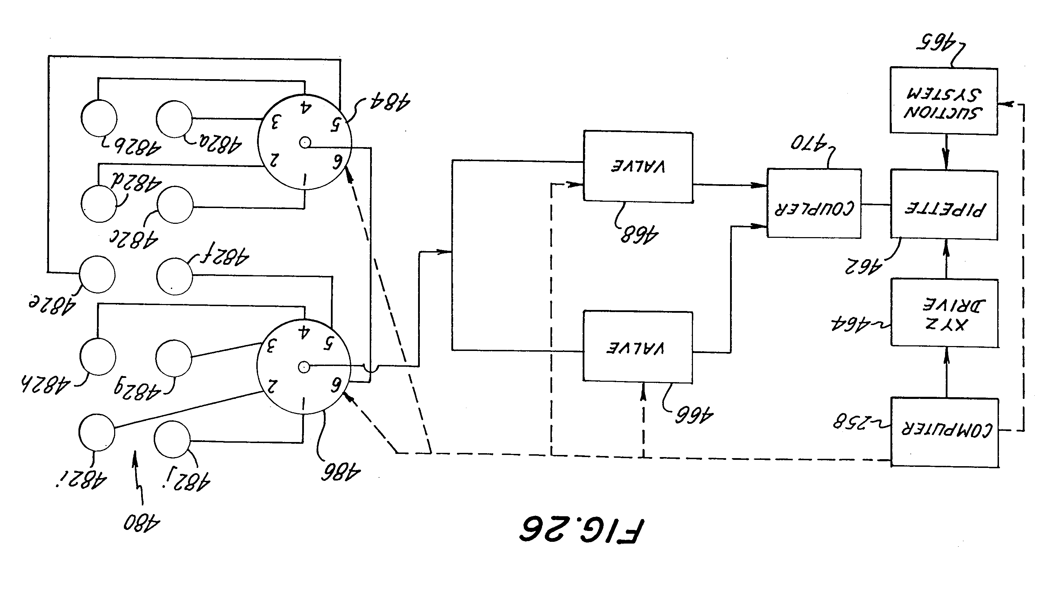

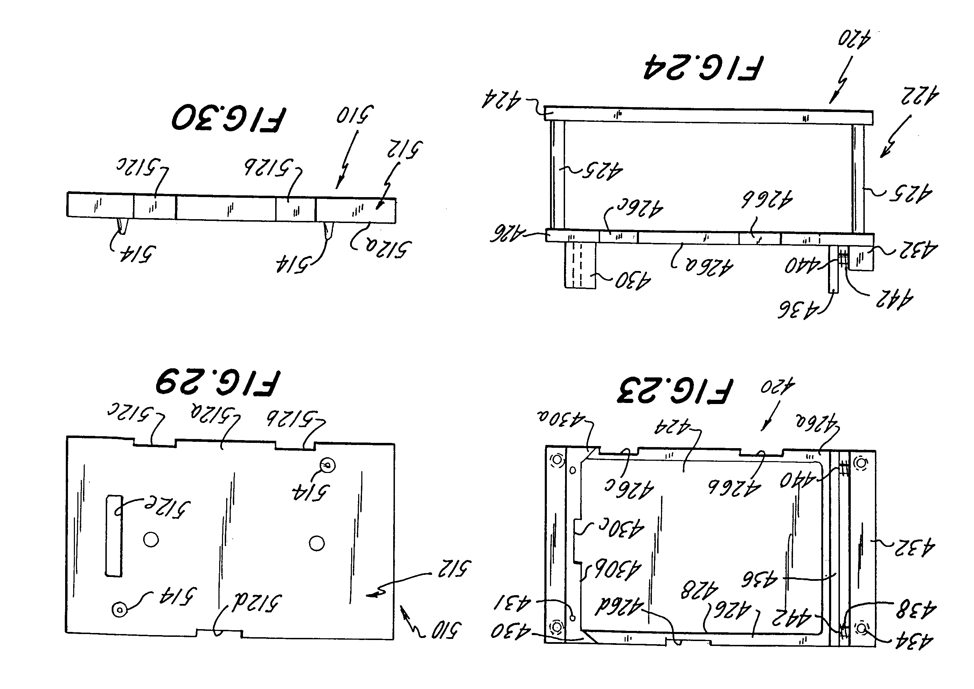

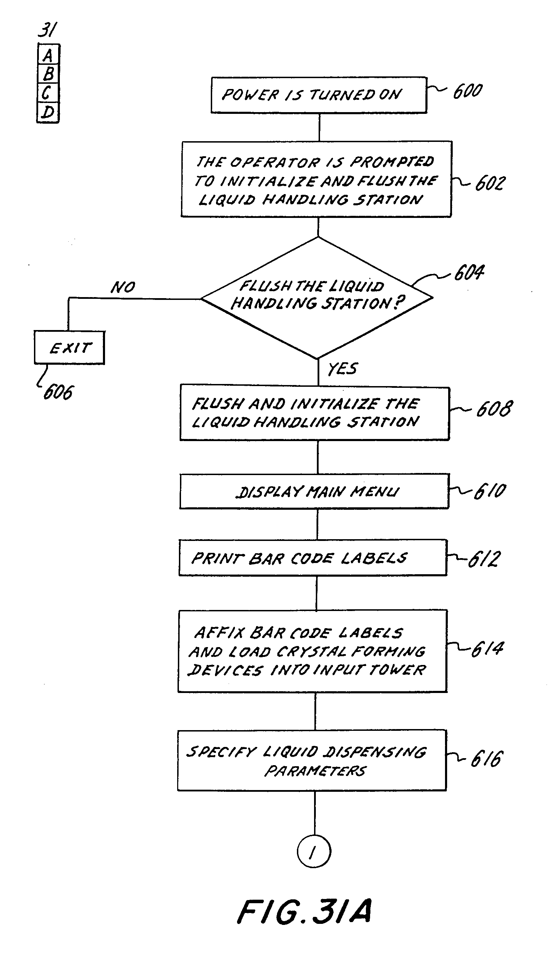

Articulated robotic arm assembly 270 then moves base plate 12 at chamber liquid dispensing-vortexing station 390 to an assembling station 510 at which base plate 12 is combined with cover 14 from rotator station 340. As shown in Figs. 8A, 29 and 30, assembling station 510 includes a support platform 512 formed from a flat metal plate of a generally rectangular configuration and having an upper surface 512a for receiving a base plate 12 thereon. Support platform 512 is formed with first and second cut-out sections 512b and 512c on one longer side thereof for receiving first and second gripping members 294 and 296, a third cut-out section 512d on the opposite longer side thereof for receiving third gripping member 297, and a fourth cut-out section 512e near one shorter side thereof for receiving stop plate 302 of gripper 282. In this manner, gripper 282 can deposit a base plate 12 onto and retrieve a base plate 12 from support platform 512. Two pins 514 are formed on upper surface 512a at two diagonally opposite corners of support platform 512, for positioning a base plate 12 thereon. When a base plate 12 is positioned on support platform 512, pins 514 just fit within the lower edge of peripheral stepped side supporting wall 36 of base plate 12 to correctly align base plate 12 on support platform 512.

Thereafter, the cover 14 from rotator station 340 is moved by articulated robotic arm assembly 270, and placed on top of the base plate 12 at assembling station 510. Articulated robotic arm assembly 270 then tamps down lightly on the upper surface of cover 14 to ensure that sealant 46 seals the individual wells of base plate 12 with cover 14.

Articulated robotic arm assembly 270 then moves the assembled crystal forming device 10 at assembling station 510 to support platform 164 of trolley assembly 162 which, in turn, moves the assembled crystal forming device 10 under and past input cassette tower 116 to a position beneath output cassette tower 160. Support platform 164 is then raised. At this time, lever actuators 240 and 242 are controlled to move pivoted levers 140 and 150 out of the way to permit passing of support platform 164 therethrough. Then, pivoted levers 140 and 150 are released at the correct time to support the processed crystal forming devices 10.

Thereafter, trolley assembly 162 moves under input cassette tower 116 to retrieve another crystal forming device 10 for processing. At the same time, articulated robotic arm assembly 270 moves the base plate 12 at sealant dispensing station 310 to chamber liquid dispensing-vortexing station 390 for processing thereat, and then moves the cover 14 at cover waiting station 420 to rotator station 340 for processing thereat.

The above operations continue until all of the crystal forming devices 10 from input cassette tower 116 are processed and returned to output cassette tower 160.

The prepared crystal forming devices 10 can then manually be removed from output cassette tower 160 and placed in the appropriate temperature environment, for example 4°C or 22°C, for equilibration and microscopic inspection over time at defined time points.

It will be appreciated that accurate dispensing and aspirating of liquids in the 1-1000 µl range is essential for reproducing conditions for crystallizing macromolecules and peptides. A difference in 0.1 pH units and ± 1 % of precipitating level can dramatically affect the equilibration rate and quality of crystals derived from any crystallization procedure. Automated crystallization system 100 performs the above steps within these parameters, while minimizing contamination problems.

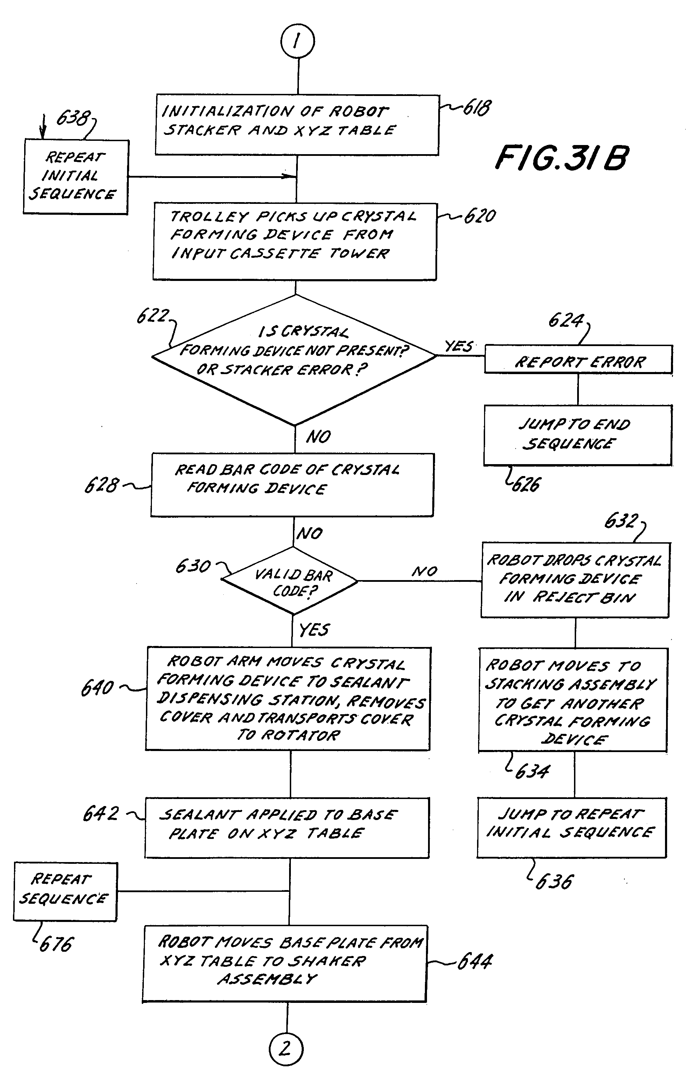

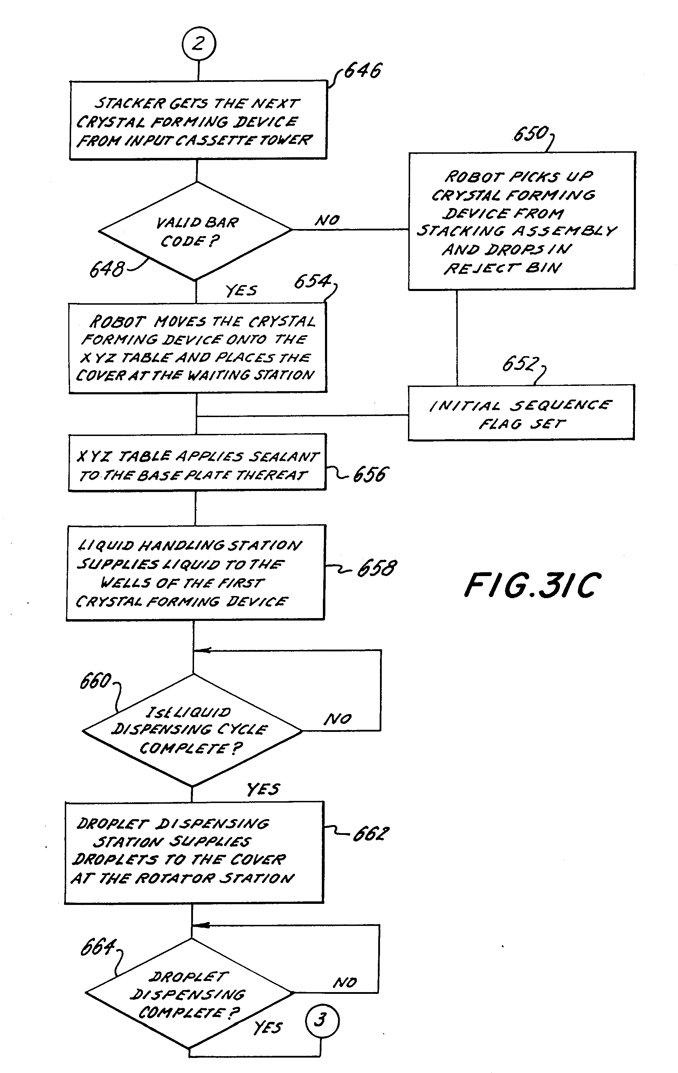

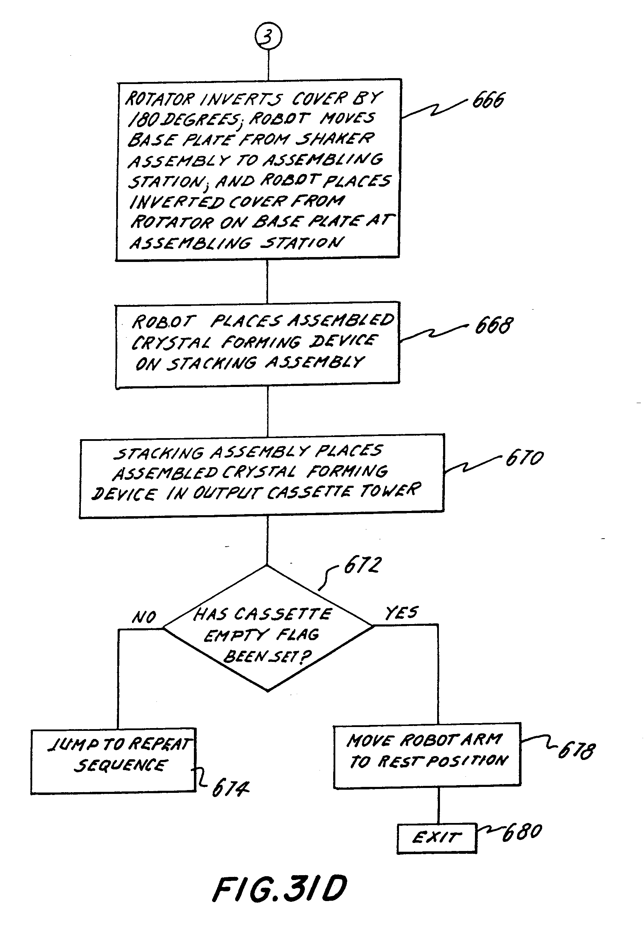

It will be appreciated that all of the above operations are controlled by computer 258 in accordance with parameters of the different experiments which are input by an operator. To illustrate the operation of automated crystallization system 100, an operating sequence flow chart, as shown in Figs. 31A-31D, will now be described.

After power for automated crystallization system 100 is turned ON in step 600, the operator is prompted by computer 258 in step 602 as to whether to initialize and flush the TECAN RSP 5052 liquid handling station 450. In Step 604, if the operator responds in the negative, computer 258 exits the program in step 606 to shut down automated crystallization system 100. On the other hand, if the operator responds in the affirmative in step 604, computer 258, in step 608, initializes and flushes all of the liquid dispensing lines of the TECAN RSP 5052 liquid handling station 450 with USP grade water. The main crystallization menu is then displayed in step 610 on computer 258.

Thereafter, in step 612, bar code labels are prepared by the operator. The operator uses a "print bar code labels" option of the main menu displayed by monitor 260. Computer 258 then instructs bar code printer 257 to print various bar code labels. In step 614, the bar code labels are affixed to the sides of base plates 12 of a plurality of crystal forming devices 10, and the labeled crystal forming devices 10 are stacked in input cassette tower 116. It is noted, however, that prior to insertion into input cassette tower 116, covers 14 of crystal forming devices 10 are siliconized as explained above.

Then, in step 616, the operator inputs the liquid handling parameters defining the composition of buffers, precipitants and special additives to be dispensed into each well 16 within crystal forming devices 10 from bulk solution dispensing station 480. Multiple experimental liquid handling parameters can be designated for multiple crystallization chambers. This is done by selecting the experimental setup menu from computer 258. All the liquid handling parameters are tagged to the bar code labels already on crystal forming devices 10.

In step 618, computer 258 initializes chamber stacking and delivery station 102, articulated robotic arm assembly 270 and sealant dispensing station 310.

In Step 620, chamber stacking and delivery station 102 is automatically activated through computer 258. Trolley assembly 162 is driven underneath input cassette tower 116 and support platform 164 thereof is raised to pick-up the lowest crystal forming device 10 in the stack contained therein. In performing this function, lever actuators 240 and 242 are pivoted so that the free ends of lever actuator 240 and 242 hit against lower ends 140a and 150a of pivoted levers 140 and 150. This results in wedge sections 140b and 150b of pivoted levers 140 and 150 being biased outwardly out of engagement with the stack of crystal forming devices 10 so that the lowest crystal forming device 10 is not carried by wedge sections 140b and 150b, but instead, is deposited and carried on the upper surface of support platform 164. Then, levers 140 and 150 are released so that the wedge sections 140b and 150b thereof support the remainder of the stack of crystal forming devices 10 within input cassette tower 116. Trolley assembly 162 is then moved out from under input cassette tower 116 with a crystal forming device 10 thereon.

On the other hand, if it is determined in step 622 that there is no crystal forming device 10 in input cassette tower 116 or if there is an error with chamber stacking and delivery station 102, an error report is generated in step 624 and the operation, in step 626, jumps to an end sequence to terminate the operation.

Assuming, however that a crystal forming device 10 is picked up by trolley assembly 162, support platform 164 is then moved to a position in front of bar code reader 256 adjacent side wall 106 of chamber stacking and delivery station 102, in step 628. If an invalid bar code is read by bar code reader 256 in step 630, articulated robotic arm assembly 270 picks up the invalid crystal forming device 10 from support platform 164 and drops the same into a reject bin (not shown), in step 632. In step 634, articulated robotic arm assembly 270 then moves to chamber stacking and delivery station 102, to pick-up another crystal forming device 10 delivered from input cassette tower 116. In step 636, the operation jumps back to step 638 to repeat the initial sequence of retrieving a crystal forming device 10.

Upon proper identification of a bar code on a retrieved crystal forming device 10, support platform 164 is lowered and transported to the front end of chamber stacking and delivery station 102, for pick-up by articulated robotic arm assembly 270.

In step 640, the gripped crystal forming device 10 from support platform 164 is picked up by the articulated robotic arm assembly 270 and placed on support platform 322 of sealant dispensing station 310. Then, articulated robotic arm assembly 270 grips cover 14 of crystal forming device 10 and removes the same from base plate 12 thereof at sealant dispensing station 310 and carries cover 14 to rotator station 340. Rotator station 340 then automatically rotates cover 14 by 180 degrees, ready for droplets 48 to be dispensed thereon.

In step 642, computer 258 then automatically activates translation table 312 to position base plate 12 below dispensing tip 332 of sealant dispenser 324. Sealant dispenser 324 is thereafter controlled to dispense sealant 46 through dispensing tip 332, while translation table 312 is moved by servo motors 316a and 316b to move flat support surface 314 and thereby support platform 322, so that sealant 46 from dispensing tip 332 is deposited on the upper circular edge 26 of each side wall of the respective base plate 12 thereat.

After sealant 46 is dispensed on upper circular edges 26 of the base plate 12 positioned on support platform 322, the base plate 12 thereat is picked up by articulated robotic arm assembly 270 and delivered to chamber liquid dispensing-vortexing station 390. This occurs in step 644.

In step 646, to increase the efficiency of automated crystallization system 100, chamber stacking and delivery station 102 retrieves the next crystal forming device 10 from input cassette tower 116.

In step 648, computer 258 determines if the next crystal forming device 10 retrieved from input cassette tower 116 has a valid bar code thereon. If not, in step 650, articulated robotic arm assembly 270 picks up the invalid crystal forming device 10 from support platform 164 and drops the same into a reject bin (not shown), as discussed above. At the same time, computer 258 sets an initial sequence flag set, in step 652.

If the bar code is valid, and with the valid crystal forming device 10 still on trolley assembly 162, articulated robotic arm assembly 270 retrieves this next crystal forming device 10 presented by chamber stacking and delivery station 102 and delivers the same onto support platform 322 of sealant dispensing station 310, in step 654. Thereafter, articulated robotic arm assembly 270 removes cover 14 of such crystal forming device 10 at sealant dispensing station 310 and supplies the same to cover waiting station 420.

In step 656, sealant dispenser 324 is thereafter controlled to dispense sealant 46 through dispensing tip 332, while translation table 312 is moved by servo motors 316a and 316b to move flat support surface 314 and thereby support platform 322, so that sealant 46 from dispensing tip 332 is deposited on the upper circular edge 26 of the side walls of base plate 12 of this second crystal forming device 10.

At the same time, in step 658, specified volumes of solutions containing a precipitating agent are supplied to each of the twenty-four wells 16 of base plate 12 at chamber liquid dispensing-vortexing station 390. The TECAN RSP 5052 liquid handling station 450 automatically dispenses specified volumes of bulk solutions from glass bottles 482a-482j of bulk solution dispensing station 480, through pipette 462, into each of the twenty-four wells of base plate 12. In between the dispensing of the liquids through six-way valves 484 and 486 from bulk solution dispensing station 480, pipette 462 is flushed to insure that there is no cross-contamination of the added liquid components. Once the dispensing operation is complete, base plate 12 is vortexed by remote activation of shaker assembly 392 for a predetermined time period (1-999 seconds) to insure uniform mixing of all of the added liquid components.

Computer 258, in step 660, determines when this first liquid dispensing cycle is complete. If it is not complete, the liquid dispensing cycle is continued until completion, at which time, computer 258 instructs droplet dispensing station 490 to deposit a droplet 48 containing a macromolecular solution within each circular bead 44 of the cover 14 positioned at rotator station 340 which correspond to wells 16 having a liquid added thereto. This occurs in step 662.

In step 664, computer 258 determines if this second liquid dispensing cycle is complete. If not, the liquid dispensing cycle is continued until completion, at which time computer 258 controls rotator station 340 to automatically rotate cover 14 by 180 degrees to its original position, in step 666. Droplets 48 deposited thereon remain in the same position, suspended from the underside of cover 14.

Articulated robotic arm assembly 270 then moves base plate 12 at chamber liquid dispensing-vortexing station 390 to an assembling station 510. Thereafter, the cover 14 from rotator station 340 is moved by articulated robotic arm assembly 270, and placed on top of the base plate 12 at assembling station 510. Articulated robotic arm assembly 270 then tamps down lightly on the upper surface of cover 14 to ensure that sealant 46 seals the individual wells of base plate 12 with cover 14.

In step 668, articulated robotic arm assembly 270 then moves the assembled crystal forming device 10 at assembling station 510 to support platform 164 of trolley assembly 162. In step 670, trolley assembly 162 then moves the assembled crystal forming device 10 past input cassette tower 116 to a position beneath output cassette tower 160. Support platform 164 is then raised. At this time, lever actuators 240 and 242 are controlled to move pivoted levers 140 and 150 out of the way to permit passing of support platform 164 therethrough. Then, pivoted levers 140 and 150 are released at the correct time to support the processed crystal forming device 10.

In step 672, computer 258 determines if a cassette empty flag has been set, which indicates that there are no more crystal forming devices 10 in input cassette tower 116. If not, another crystal forming device 10 is retrieved from input cassette tower 116 to repeat the above steps, that is, the operation moves to step 674, which jumps to the repeat sequence of step 676. If yes, articulated robotic arm assembly 270 is moved to a rest position in step 678, and the operation stops in step 680.

The prepared crystal forming devices 10 can then manually be removed from output cassette tower 160 and placed in the appropriate temperature environment, for example 4C or 22C, for equilibration and microscopic inspection over time at various post set-up times (e.g. 3 days, 1 week, 1 month, 3 months and 6 months).

Automated crystallization system 100 was tested over extended time periods (24-48 hours) of continuous operation.

Using a published procedure for crystallizing chicken lysozyme, as described above, lysozyme was successfully crystallized. The size and quality of these crystals were comparable to crystals obtained from manually prepared hanging drop experiments set up in parallel.

Having described specific preferred embodiments of the invention with reference to the accompanying drawings, it will be appreciated that the present invention is not limited to those precise embodiments and that various changes and modifications can be effected therein by one of ordinary skill in the art without departing from the scope or spirit of the invention as defined by the appended claims.

## Claims

1. A crystal forming device comprising:
(a) a base plate having a plurality of wells therein, each well adapted to receive a reservoir solution therein and each well having a bottom and a circumferential side wall connected with said bottom to define a chamber therein, the side wall having an upper circumferential edge defining an upper opening of the well; and
(b) single removable cover means for covering all of said wells, said single removable cover means having a lower surface which rests on said upper circumferential edges of said wells to seal said wells and to thereby seal said chambers.

2. The crystal forming device of claim 1 which further comprises sealing means between said upper circumferential edges and said single removable cover means, for sealing the lower surface of said single removable cover means to each said well to define a plurality of sealed chambers.

3. A method for forming macromolecular crystals, comprising the steps of:
(a) dispensing a reservoir solution in a plurality of wells formed in a base plate, with each well having a bottom and a circumferential side wall connected with said bottom to define a chamber therein, each said side wall having an upper circumferential edge defining an upper opening of the well through which the reservoir solution is dispensed;
(b) forming a plurality of droplets containing a macromolecular solution on a single cover, at positions in correspondence to said wells supplied with said reservoir solution;
(c) inverting said single cover such that said droplets remain substantially in the same positions on the single cover; and
(d) positioning said inverted single cover on said upper circumferential edges to seal said chambers, with each said droplet hanging in a suspended state over the reservoir in a respective well.

4. The method of claim 3 which further comprises a step of sealing the lower surface of said single removable cover means to each said well to thereby define a plurality of sealed chambers.

5. An automated crystallization system comprising:
(a) liquid dispensing means for dispensing a reservoir solution in a plurality of wells formed in a base plate, each well formed by a side wall having an upper circumferential edge defining an upper opening of the well through which the reservoir solution is dispensed;
(b) droplet dispensing means for depositing a plurality of droplets containing a macromolecular solution on an upwardly facing lower surface of a cover, at positions in correspondence to said wells supplied with said reservoir solution;
(c) inverting means for inverting said cover after said droplets have been deposited thereon, such that said lower surface thereof faces downwardly; and
(d) positioning means for positioning said inverted cover on said upper circumferential edges so that said cover seals a plurality of said wells, wherein said droplets hang in a suspended state over the respective reservoir solutions.

6. The automated crystallization system of claim 5 in which said liquid dispensing means comprises:
(a) support platform means for supporting said base plate;
(b) pipette means for supplying the reservoir solution to each well of said base plate; and
(c) drive means for providing relative movement between said pipette means and said support platform means such that said pipette means can be selectively positioned over any one of said wells.

7. The automated crystallization system of either claim 5 or claim 6 in which said inverting means comprises:
(a) support platform means for supporting said cover below said droplet dispensing means; and
(b) rotation support means for rotatably supporting said support platform means between a position where the lower surface of the cover is facing upwardly to deposit the droplets thereon and a position where the lower surface of the cover is facing downwardly after the droplets are deposited on said lower surface.

8. The automated crystallization system of any one of claims 5 to 7 in which said positioning means comprises articulated robotic arm means for gripping and carrying said base plate to and from said liquid dispensing means and for gripping and carrying said cover to and from said inverting means.

9. An automated crystallization system for use with a crystal forming device having a base plate with a plurality of wells therein and a cover for covering a plurality of said wells, said automated crystallization system comprising:
(a) chamber stacking means for stacking a plurality of said crystal forming devices;
(b) processing means for processing said crystal forming devices from said chamber stacking means, said processing means including:
(i) liquid dispensing means for dispensing predetermined amounts of liquids into the wells of the base plate of each said crystal forming device, and
(ii) droplet dispensing means for dispensing a droplet containing a macromolecular solution at each position on said cover corresponding to said wells such that said droplets hang in a suspended state from said cover over each well when said cover is assembled with a respective base plate; and
(c) articulated robotic arm means for gripping and carrying said crystal forming devices between said chamber stacking means and said processing means, and for disassembling and assembling the cover of each said crystal forming device with the base plate thereof.

10. The automated crystallization system of claim 9 in which said liquid dispensing means comprises:
(a) support platform means for supporting said base plate;
(b) pipette means for supplying the reservoir solution to each well of said base plate; and
(c) drive means for providing relative movement between said pipette means and said support platform means such that said pipette means can be selectively positioned over any one of said wells.

11. The automated crystallization system of either claim 9 or claim 10 which further comprises rotator means for rotating the cover of each said crystal forming device between a position where the lower surface of the cover is facing upwardly to deposit the droplets thereon and a position where the lower surface of the cover is facing downwardly after the droplets are deposited on said lower surface, said rotator means including support platform means for supporting said cover below said droplet dispensing means, and rotation support means for rotatably supporting said support platform means between a position where the lower surface of the cover is facing upwardly to deposit the droplets thereon and a position where the lower surface of the cover is facing downwardly after the droplets are deposited on said lower surface.

12. The automated crystallization system of any one of claims 9 to 11 in which said droplet dispensing means comprises:
(a) pipette means for supplying the droplets to said cover; and
(b) drive means for providing relative movement between said pipette means and said cover such that said
(b) drive means for providing relative movement between said pipette means and said cover such that said pipette means can be selectively positioned at different locations over the upwardly facing lower surface of the cover.

13. The automated crystallization system of any one of claims 9 to 12 in which said articulated robotic arm means comprises:
(a) gripping means for gripping said base plate and said cover, said gripping means including first and second gripping arms; and
(b) wrist means for holding said gripping arms in spaced apart relationship, said wrist means including gripping adjustment means for moving said gripping arms toward and away from each other.

14. The automated crystallization system of any one of claims 9 to 13 which further comprises trolley means for retrieving said crystal forming devices from said chamber stacking means and for returning said crystal forming devices to said chamber stacking means after processing thereof has been completed.

15. The automated crystallization system of any one of claims 9 to 14 in which said chamber stacking means comprises:
(a) input tower means for holding a stack of said crystal forming devices to be processed, and
(b) output tower means for holding a stack of processed crystal forming devices.

16. An automated crystallization system for use with a crystal forming device having a base plate with a plurality of wells therein, each well adapted to receive a reservoir solution therein and each well having a bottom and a circumferential side wall connected with said bottom to define a chamber therein, the side wall having an upper circumferential edge defining an upper opening of the well, and removable cover for covering all of said wells, said removable cover having a lower surface which rests on said upper circumferential edges of said wells to seal said wells and to thereby seal said chambers, said automated crystallization system comprising:
(a) chamber stacking means for stacking a plurality of said crystal forming devices;
(b) processing means for processing said crystal forming devices from said chamber stacking means, said processing means comprising:
(i) sealant dispenser means for applying a sealant to the upper circumferential edge of the side wall of the base plate of each said crystal forming device,
(ii) liquid dispensing means for dispensing predetermined amounts of liquids into the wells of the base plate of each said crystal forming device,
(iii) droplet dispensing means for dispensing a droplet containing a macromolecular solution at each position on said cover corresponding to said wells such that said droplets hang in a suspended state from said cover over each said well when said cover is assembled with a respective said base plate, and
(iv) rotator means for rotating the cover of each said crystal forming device between a position where the lower surface of the cover is facing upwardly to deposit the droplets thereon and a position where the lower surface of the cover is facing downwardly after the droplets are deposited on said lower surface and when said cover is assembled with a respective said base plate; and
(c) articulated robotic arm means for gripping and carrying said crystal forming devices between said chamber stacking means and said processing means, and for disassembling and assembling the cover of each said crystal forming device with the base plate thereof.
